(19) Europäisches Patentamt
European Patent Office
Office européen des brevets

(11) EP 3 573 119 A1

(12) EUROPEAN PATENT APPLICATION
published in accordance with Art. 153(4) EPC

(43) Date of publication:
**27.11.2019 Bulletin 2019/48**

(21) Application number: **18741729.0**

(22) Date of filing: **18.01.2018**

(51) Int Cl.:
***H01L 51/50*** (2006.01) ***C08G 65/12*** (2006.01)
***C08K 5/17*** (2006.01) ***C08L 65/00*** (2006.01)
***C09D 11/02*** (2014.01)

(86) International application number:
**PCT/JP2018/001381**

(87) International publication number:
**WO 2018/135581 (26.07.2018 Gazette 2018/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority: **18.01.2017 JP 2017007065**
**28.06.2017 JP 2017126779**

(71) Applicant: **Nissan Chemical Corporation**
**Tokyo 103-6119 (JP)**

(72) Inventors:
- **MAEDA Daisuke**
**Funabashi-shi**
**Chiba 274-0052 (JP)**
- **ENDO Toshiyuki**
**Funabashi-shi**
**Chiba 274-0052 (JP)**

(74) Representative: **Mewburn Ellis LLP**
**City Tower**
**40 Basinghall Street**
**London EC2V 5DE (GB)**

# (54) INK COMPOSITION CONTAINING SULFONATED CONJUGATED POLYMER

(57) Provided is a composition comprising a sulfonated conjugated polymer having excellent dispersibility in organic solvents used during the manufacture of OLED devices. An ink composition comprising (a) a sulfonated conjugated polymer treated with a reducing agent, (b) at least one amine compound, and(c) a liquid carrier comprising at least one organic solvent.

EP 3 573 119 A1

**Description**

**TECHNICAL FIELD**

This application claims priority to Japanese Patent Application No. 2017-007065, filed on Jan. 18, 2017, and Japanese Patent Application No. 2017-126779, filed on Jun. 28, 2017. The entire contents of these applications are expressly incorporated herein by this reference.

The present invention relates to an ink composition comprising a sulfonated conjugated polymer obtained by treating with a reducing agent a sulfonated conjugated polymer comprising a repeating unit having a quinoid structure, an amine compound, and a liquid medium.

**BACKGROUND ART**

Although useful advances are being made in energy saving devices such as, for example, organic-based organic light emitting diodes (OLEDs), polymer light emitting diodes (PLEDs), phosphorescent organic light emitting diodes (PHOLEDs), and organic photovoltaic devices (OPVs), further improvements are still needed in providing better materials processing and/or device performance for commercialization. For example, one promising type of material used in organic electronics is the conducting polymers including, for example, polythiophenes. However, problems can arise with polymers' purity, processability, and instability in their neutral and/or conductive states. Also, it is important to have very good control over the solubility of polymers utilized in alternating layers of various devices' architectures (e.g., orthogonal or alternating solubility properties among adjacent layers in particular device architecture). These layers, for example, also known as hole injection layers (HILs) and hole transport layers (HTLs), can present difficult problems in view of competing demands and the need for very thin, but high quality, films.

In a typical OLED device stack, the refractive index for most p-doped polymeric HILs is around 1.5, such as HILs comprising PEDOT:PSS, while the emissive materials generally have a refractive index that is substantially higher (1.7 or higher). As a result, additional total internal reflection occurs at EML/HIL (or HTL/HIL) and HIL/ITO interfaces, leading to reduced light extraction efficiency.

There is an ongoing unresolved need for a good platform system to control properties of hole injection and transport layers, such as solubility, thermal/chemical stability, and electronic energy levels, such as HOMO and LUMO, so that the compounds can be adapted for different applications and to function with different compounds, such as light emitting layers, photoactive layers, and electrodes. Good solubility, intractability, and thermal stability properties are important. Also of importance is the ability to tune HIL resistivity and HIL layer thickness while retaining high transparency, low absorptivity, low internal reflection, low operating voltage, within the OLED system, and prolonged lifetime, among other properties. The ability to formulate the system for a particular application and provide the required balance of such properties is also important.

Patent Document 1 discloses an ink composition containing a sulfonated conjugated polymer and an amine compound.

Not only does the presence of an amine compound in the ink composition provide an ink composition having a good shelf life and stability, but films formed from the ink composition exhibit excellent homogeneity and OLED devices comprising an HIL formed from the ink composition exhibit good performance.

However, such improved dispersibility of sulfonated conjugated polymers in various organic solvents used in the fabrication of OLED devices is not necessarily obtained in a stable manner.

Sulfonated conjugated polymers, such as sulfonated polythiophenes, are known to vary in dispersibility in organic solvents, even if they are produced according to the same specifications. Among these sulfonated conjugated polymers, those having low dispersibility have been observed to show insufficient improvement in dispersibility even when an amine compound is added as described above, thereby being unable to provide a good ink composition.

Such variability in dispersibility has made it difficult to produce sulfonated conjugated polymers with improved dispersibility in organic solvents in a stable manner. The cause of such variation in dispersion has not been known so far.

**PRIOR ART DOCUMENTS**

**Patent Documents**

Patent Document 1: WO 2016/171935

## SUMMARY

### Problems to be Solved by the Invention

The present invention was made in view of the above circumstances, and an object of the present invention is to provide compositions comprising sulfonated conjugated polymers having excellent dispersibility in organic solvents used in the manufacture of OLED devices.

It is also an object of the invention to provide the ability to tune electrical properties, thermal, and operational stability to unable increased lifetime, of HILs in a device comprising the compositions described herein.

It is another object of the present invention to provide the ability to tune film thickness and retain high transparency or low absorbance in the visible spectrum (transmittance >90%T) in a device comprising the compositions described herein.

### Means for Solving the Problems

The present inventors carried out intensive research to elucidate the causes of such variation in the dispersibility of sulfonated conjugated polymer in organic solvents. As a result, it has surprisingly been found that, in some cases, the chemical structure in some of the repeating units constituting the sulfonated conjugated polymer is an oxidized structure called a "quinoid structure," which decreases the dispersibility of the polymer in organic solvents, and that a sulfonated conjugated polymer treated with a reducing agent to decrease the amount of quinoid structure exhibits extremely good dispersibility in organic solvents in the presence of amine compounds and is extremely useful for stable production of good ink compositions that provide charge transporting films with excellent homogeneity.

Based on the findings above, the present invention has been completed.

That is, the present invention provides the following inventions.

1. An ink composition comprising:

   (a) a sulfonated conjugated polymer obtained by treating with a reducing agent a sulfonated conjugated polymer comprising a repeating unit having a quinoid structure;
   (b) at least one amine compound; and
   (c) a liquid carrier comprising at least one organic solvent.

2. The ink composition according to preceding item 1, wherein the reducing agent is ammonia or hydrazine.
3. The ink composition according to preceding item 1 or 2, wherein the amine compound comprises a tertiary alkylamine compound and an amine compound other than a tertiary alkylamine compound.
4. The ink composition according to preceding item 3, wherein the amine compound other than a tertiary alkylamine compound is a primary alkylamine compound.
5. The ink composition according to preceding item 4, wherein the primary alkylamine compound is at least one selected from the group consisting of ethylamine, n-butylamine, t-butylamine, n-hexylamine, 2-ethylhexylamine, n-decylamine, and ethylenediamine.
6. The ink composition according to preceding item 5, wherein the primary alkylamine compound is 2-ethylhexylamine or n-butylamine.
7. The ink composition according to any one of preceding items 1 to 6, wherein the sulfonated conjugated polymer is a sulfonated polythiophene.
8. The ink composition according to preceding item 7, wherein the sulfonated polythiophene is a sulfonated polythiophene comprising a repeating unit complying with formula (I):

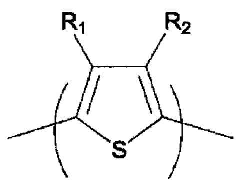

(I)

wherein $R_1$ and $R_2$ are each, independently, H, alkyl, fluoroalkyl, alkoxy, aryloxy, or $-O-[Z-O]_p-R_e$;
wherein

Z is an optionally halogenated hydrocarbylene group,

p is equal to or greater than 1, and
$R_e$ is H, alkyl, fluoroalkyl, or aryl;

provided that either $R_1$ or $R_2$ is $-SO_3M$, wherein M is H, an alkali-metal ion, ammonium, a monoalkylammonium, a dialkylammonium, or a trialkylammonium.

9. The ink composition according to preceding item 8, wherein $R_1$ and $R_2$ are each, independently, H, fluoroalkyl, $-O[C(R_aR_b)-C(R_cR_d)-O]_p-R_e$, $-OR_f$; wherein each occurrence of $R_a$, $R_b$, $R_c$, and $R_d$, is each, independently, H, alkyl, fluoroalkyl, or aryl; $R_e$ is H, alkyl, fluoroalkyl, or aryl; p is 1, 2, or 3; and $R_f$ is alkyl, fluoroalkyl, or aryl.

10. The ink composition according to preceding item 8, wherein $R_1$ is - $SO_3M$ and $R_2$ is other than $-SO_3M$.

11. The ink composition according to preceding item 10, wherein $R_1$ is - $SO_3M$ and $R_2$ is $-O[C(R_aR_b)-C(R_cR_d)-O]_p-R_e$, or $-OR_f$.

12. The ink composition according to preceding item 11, wherein $R_1$ is - $SO_3M$ and $R_2$ is $-O[C(R_aR_b)-C(R_cR_d)-O]_p-R_e$.

13. The ink composition according to preceding item 12, wherein $R_1$ is - $SO_3M$ and $R_2$ is $-O-CH_2CH_2-O-CH_2CH_2-O-CH_3$.

14. The ink composition according to any one of preceding items 8 to 13, wherein the sulfonated polythiophene is sulfonated poly(3-MEET).

15. The ink composition according to any one of preceding items 8 to 14, wherein the sulfonated polythiophene is obtained by sulfonation of a polythiophene comprising repeating units complying with formula (I) in an amount of greater than 70% by weight, typically greater than 80% by weight, more typically greater than 90% by weight, even more typically greater than 95% by weight, based on the total weight of the repeating units.

16. The ink composition according to any one of preceding items 1 to 15, wherein the liquid carrier is a liquid carrier comprising at least one glycol-based solvent (A) and at least one organic solvent (B) other than a glycol-based solvent.

17. The ink composition according to preceding item 16, wherein the glycol-based solvent (A) is a glycol ether, a glycol monoether, or a glycol.

18. The ink composition according to preceding item 16 or 17, wherein the organic solvent (B) is a nitrile, an alcohol, an aromatic ether, or an aromatic hydrocarbon.

19. The ink composition according to any one of preceding items 16 to 18, wherein the amount of glycol-based solvent (A): wtA (in weight) and the amount of organic solvent (B) (in weight): wtB (in weight) satisfy formula (1-1).

$$0.05 \leq wtB / (wtA + wtB) \leq 0.50 \qquad (1\text{-}1)$$

20. The ink composition according to any one of preceding items 1 to 19, wherein the non-aqueous ink composition further comprises one or more metal oxide nanoparticles.

21. The ink composition according to preceding item 20, wherein the metal oxide nanoparticles comprise $B_2O_3$, $B_2O$, $SiO_2$, SiO, $GeO_2$, GeO, $As_2O_4$, $As_2O_3$, $As_2O_5$, $Sb_2O_3$, $TeO_2$, $SnO_2$, SnO, or mixtures thereof.

22. The ink composition according to preceding item 21, wherein the metal oxide nanoparticles comprise $SiO_2$.

23. The ink composition according to any one of preceding items 1 to 22, wherein the ink composition further comprises a synthetic polymer comprising one or more acidic groups.

24. The ink composition according to preceding item 23, wherein the synthetic polymer is a polymeric acid comprising one or more repeating units comprising at least one alkyl or alkoxy group substituted by at least one fluorine atom and at least one sulfonic acid ($-SO_3H$) moiety, wherein said alkyl or alkoxy group is optionally interrupted by at least one ether linking (-O-) group.

25. The ink composition according to preceding item 24, wherein the polymeric acid comprises a repeating unit complying with formula (II) and a repeating unit complying with formula (III):

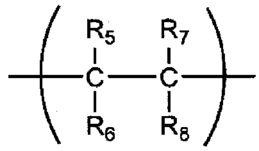

(II)

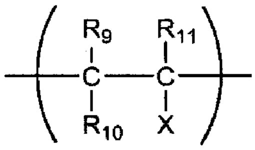

(III)

wherein

each occurrence of $R_5$, $R_6$, $R_7$, $R_8$, $R_9$, $R_{10}$, and $R_{11}$ is, independently, H, halogen, fluoroalkyl, or perfluoroalkyl; and
X is $-[OC(R_hR_i)-C(R_jR_k)]_q-O-[CR_lR_m]_z-SO_3H$,
wherein each occurrence of $R_h$, $R_i$, $R_j$, $R_k$, $R_l$ and $R_m$ is, independently, H, halogen, fluoroalkyl, or perfluoroalkyl;
q is 0 to 10; and
z is 1 to 5.

26. An ink composition comprising:

(a) a sulfonated conjugated polymer obtained by treating with a reducing agent a sulfonated conjugated polymer comprising a repeating unit having a quinoid structure;
(b) at least one amine compound;
(c) a liquid carrier comprising at least one organic solvent;
(d) one or more metal oxide nanoparticles; and
(e) optionally, a synthetic polymer comprising one or more acidic groups.

**Effect of the Invention**

According to the present invention, it is possible to stably provide sulfonated conjugated polymers having excellent dispersibility in organic solvents used in the manufacture of OLED devices and ink compositions comprising the same.
It is also possible to provide the ability to tune electrical properties, thermal, and operational stability to unable increased lifetime, of HILs in a device comprising the compositions described herein.
Further, It is possible provide the ability to tune film thickness and retain high transparency or low absorbance in the visible spectrum (transmittance >90%T) in a device comprising the compositions described herein.

**Description of Embodiments**

As used herein, the terms "a", "an", or "the" means "one or more" or "at least one" unless otherwise stated.
As used herein, the term "comprises" includes "consists essentially of' and "consists of." The term "comprising" includes "consisting essentially of' and "consisting of."
The phrase "free of' means that there is no external addition of the material modified by the phrase and that there is no detectable amount of the material that may be observed by analytical techniques known to the ordinarily-skilled artisan, such as, for example, gas or liquid chromatography, spectrophotometry, optical microscopy, and the like.
Throughout the present invention, various publications may be incorporated by reference. Should the meaning of any language in such publications incorporated by reference conflict with the meaning of the language of the present invention, the meaning of the language of the present invention shall take precedence, unless otherwise indicated.
As used herein, the terminology "($C_x$-$C_y$)" in reference to an organic group, wherein x and y are each integers, means that the group may contain from x carbon atoms to y carbon atoms per group.
As used herein, the term "alkyl" means a monovalent straight or branched saturated hydrocarbon radical, more typically, a monovalent straight or branched saturated ($C_1$-$C_{40}$) hydrocarbon radical, such as, for example, methyl, ethyl, n-propyl, isopropyl, n-butyl, isobutyl, tert-butyl, hexyl, 2-ethylhexyl, octyl, hexadecyl, octadecyl, eicosyl, behenyl, tricontyl, and tetracontyl.
As used herein, the term "fluoroalkyl" means an alkyl radical as defined herein, more typically a ($C_1$-$C_{40}$) alkyl radical that is substituted with one or more fluorine atoms. Examples of fluoroalkyl groups include, for example, difluoromethyl, trifluoromethyl, perfluoroalkyl, 1H,1H,2H,2H-perfluorooctyl, perfluoroethyl, and - $CH_2CF_3$.
As used herein, the term "hydrocarbylene" means a divalent radical formed by removing two hydrogen atoms from a hydrocarbon, typically a ($C_1$-$C_{40}$) hydrocarbon. Hydrocarbylene groups may be straight, branched or cyclic, and may be saturated or unsaturated. Examples of hydrocarbylene groups include, but are not limited to, methylene, ethylene,

1-methylethylene, 1-phenylethylene, propylene, butylene, 1,2-benzene; 1,3-benzene; 1,4-benzene; and 2,6-naphthalene.

As used herein, the term "alkoxy" means a monovalent radical denoted as - O-alkyl, wherein the alkyl group is as defined herein. Examples of alkoxy groups, include, but are not limited to, methoxy, ethoxy, n-propoxy, isopropoxy, n-butoxy, isobutoxy, and tert-butoxy.

As used herein, the term "aryl" means a monovalent unsaturated hydrocarbon radical containing one or more six-membered carbon rings in which the unsaturation may be represented by three conjugated double bonds. Aryl radicals include monocyclic aryl and polycyclic aryl. Polycyclic aryl refers to a monovalent unsaturated hydrocarbon radical containing more than one six-membered carbon ring in which the unsaturation may be represented by three conjugated double bonds wherein adjacent rings may be linked to each other by one or more bonds or divalent bridging groups or may be fused together. Examples of aryl radicals include, but are not limited to, phenyl, anthracenyl, naphthyl, phenanthrenyl, fluorenyl, and pyrenyl.

As used herein, the term "aryloxy" means a monovalent radical denoted as - O-aryl, wherein the aryl group is as defined herein. Examples of aryloxy groups, include, but are not limited to, phenoxy, anthracenoxy, naphthoxy, phenanthrenoxy, and fluorenoxy.

Any substituent or radical described herein may optionally be substituted at one or more carbon atoms with one or more, same or different, substituents described herein. For instance, a hydrocarbylene group may be further substituted with an aryl group or an alkyl group. Any substituent or radical described herein may also optionally be substituted at one or more carbon atoms with one or more substituents selected from the group consisting of halogen, such as, for example, F, Cl, Br, and I; nitro ($NO_2$), cyano (CN), and hydroxy (OH).

As used herein, the term "hole carrier compound" refers to any compound that is capable of facilitating the movement of holes, i.e., positive charge carriers, and/or blocking the movement of electrons, for example, in an electronic device. Hole carrier compounds include compounds useful in layers (HTLs), hole injection layers (HILs) and electron blocking layers (EBLs) of electronic devices, typically organic electronic devices, such as, for example, organic light emitting devices.

As used herein, the term "doped" in reference to a hole carrier compound, for example, a polythiophene polymer, means that the hole carrier compound has undergone a chemical transformation, typically an oxidation or reduction reaction, more typically an oxidation reaction, facilitated by a dopant. As used herein, the term "dopant" refers to a substance that oxidizes or reduces, typically oxidizes, a hole carrier compound, for example, a polythiophene polymer. Herein, the process wherein a hole carrier compound undergoes a chemical transformation, typically an oxidation or reduction reaction, more typically an oxidation reaction, facilitated by a dopant is called a "doping reaction" or simply "doping". Doping alters the properties of the polythiophene polymer, which properties may include, but may not be limited to, electrical properties, such as resistivity and work function, mechanical properties, and optical properties. In the course of a doping reaction, the hole carrier compound becomes charged, and the dopant, as a result of the doping reaction, becomes the oppositely-charged counterion for the doped hole carrier compound. As used herein, a substance must chemically react, oxidize or reduce, typically oxidize, a hole carrier compound to be referred to as a dopant. Substances that do not react with the hole carrier compound but may act as counterions are not considered dopants according to the present invention. Accordingly, the term "undoped" in reference to a hole carrier compound, for example a polythiophene polymer, means that the hole carrier compound has not undergone a doping reaction as described herein.

The ink composition of the present disclosure may be non-aqueous or may comprise water, but is preferably non-aqueous from the perspective of process compatibility in inkjet coating and the storage stability of the ink. As used herein, "non-aqueous" means that the total amount of water in the ink composition of the present invention is from 0 to 2 wt. %, with respect to the total amount of ink composition. Typically, the total amount of water in the ink composition is from 0 to 1 wt. %, more typically from 0 to 0.5 wt. %, with respect to the total amount of the ink composition. In an embodiment, the non-aqueous ink composition of the present invention is substantially free of water.

Sulfonated conjugated polymers suitable for use in the ink compositions of the present invention are polymers and copolymers prepared by sulfonation of conjugated polymers or copolymers and/or polymerization of sulfonated monomers. Conjugated polymers and/or copolymers that may be sulfonated include, for example, linear conjugated polymers or conjugated polymer brushes, random, statistical, block and/or alternating copolymers. As used herein, "conjugated polymer" refers to any polymer and/or copolymer having a backbone comprising a continuous system of $sp^2$-hybridized orbitals over which $\pi$ electrons can delocalize.

Sulfonated conjugated polymers suitable for use in the ink compositions of the present invention comprise one or more sulfonic acid groups ($-SO_3H$). As used herein, the term "sulfonated" in relation to a conjugated polymer means that the sulfur atom of the $-SO_3H$ group is directly bonded to the backbone of the conjugated polymer and not to a side group. For the purpose of the present invention, a side group is a monovalent radical that when theoretically or actually removed from the polymer does not shorten the length of the polymer chain. The sulfonated conjugated polymer and/or copolymer may be made using any method known to those of ordinary skill in the art. For example, a conjugated polymer may be sulfonated by reacting the conjugated polymer with a sulfonating reagent such as, for example, fuming sulfuric

acid, acetyl sulfate, pyridine $SO_3$, or the like. In another example, monomers may be sulfonated using a sulfonating reagent and then polymerized according to known methods.

It will be clear to a person skilled in the art that sulfonic acid groups in the presence of a basic compound, for example, alkali metal hydroxides, ammonia, and alkylamines, such as, for example, mono-, di-, and trialkylamines, such as, for example, triethylamine, may result in the formation of the corresponding salt or adduct. Thus, the term "sulfonated" in relation to the polythiophene polymer includes the meaning that the polythiophene may comprise one or more $-SO_3M$ groups, wherein M may be an alkali metal ion, such as, for example, $Na^+$, $Li^+$, $K^+$, $Rb^+$, $Cs^+$; ammonium ($NH_4^+$), mono-, di-, and trialkylammonium, such as triethylammonium.

Conjugated polymers that may be sulfonated according to the present invention may be homopolymers, copolymers, including statistical, random, gradient, and block copolymers. For a polymer comprising a monomer A and a monomer B, block copolymers include, for example, A-B diblock copolymers, A-B-A triblock copolymers, and $-(AB)_n$-multiblock copolymers. Synthetic methods, doping, and polymer characterization, including regioregular polythiophenes with side groups, are provided in, for example, U.S. Patent No. 6,602,974 to McCullough et al. and U.S. Patent No. 6,166,172 to McCullough et al., the entireties of which are hereby incorporated by reference.

Examples of conjugated polymers that may be sulfonated include, but are not limited to, polythiophenes, polythienothiophenes, polyselenophenes, polypyrroles, polyfurans, polytellurophenes, polyanilines, polyarylamines, and polyarylenes (e.g., polyphenylenes, polyphenylene vinylenes, and polyfluorenes. The above conjugated polymers may have side groups that are electron-withdrawing or electron-releasing groups. The side groups may provide for better solubility.

In an embodiment, the sulfonated conjugated polymer is a sulfonated polythiophene.

The sulfonation of conjugated polymers and sulfonated conjugated polymers, including sulfonated polythiophenes, are described in U.S. Patent No. 8,017,241 to Seshadri et al., which is incorporated herein by reference in its entirety.

Also, sulfonated polythiophenes are described in WO 2008/073149 and WO 2016/171935, which are incorporated herein by reference in their entirety.

In an embodiment, the sulfonated polythiophene comprises a repeating unit complying with formula (I):

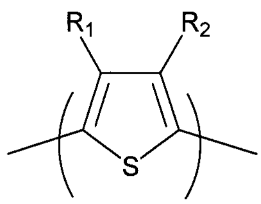

(I)

wherein $R_1$ and $R_2$ are each, independently, H, alkyl, fluoroalkyl, alkoxy, aryloxy, or $-O-[Z-O]_p-R_e$;
wherein

Z is an optionally halogenated hydrocarbylene group,
p is equal to or greater than 1, and
$R_e$ is H, alkyl, fluoroalkyl, or aryl;

provided that either $R_1$ or $R_2$ is $-SO_3M$, wherein M is H, an alkali-metal ion, ammonium, a monoalkylammonium, a dialkylammonium, or a trialkylammonium.

In an embodiment, $R_1$ and $R_2$ are each, independently, H, fluoroalkyl, $-O[C(R_aR_b)-C(R_cR_d)-O]_p-R_e$, $-OR_f$; wherein each occurrence of $R_a$, $R_b$, $R_c$, and $R_d$ is each, independently, H, alkyl, fluoroalkyl, or aryl; $R_e$ is H, alkyl, fluoroalkyl, or aryl; p is 1, 2, or 3; and $R_f$ is alkyl, fluoroalkyl, or aryl.

In an embodiment, $R_1$ is $-SO_3M$ and $R_2$ is other than $-SO_3M$. In such an embodiment, the repeating unit is derived from a 3-substituted thiophene.

The sulfonated polythiophene can be obtained from a polythiophene that may be a regiorandom or a regioregular compound. Due to its asymmetrical structure, the polymerization of 3-substituted thiophenes produces a mixture of polythiophene structures containing three possible regiochemical linkages between repeat units. The three orientations available when two thiophene rings are joined are the 2,2'; 2,5', and 5,5' couplings. The 2,2' (or head-to-head) coupling and the 5,5' (or tail-to-tail) coupling are referred to as regiorandom couplings. In contrast, the 2,5' (or head-to-tail) coupling is referred to as a regioregular coupling. The degree of regioregularity can be, for example, about 0 to 100%, or about 25 to 99.9%, or about 50 to 98%. Regioregularity may be determined by standard methods known to those of ordinary skill in the art, such as, for example, using NMR spectroscopy.

3-substituted thiophene monomers, including polymers derived from such monomers, are commercially-available or may be made by methods known to those of ordinary skill in the art. Synthetic methods, doping, and polymer characterization, including regioregular polythiophenes with side groups, are provided in, for example, U.S. Patent No. 6,602,974 to McCullough et al. and U.S. Patent No. 6,166,172 to McCullough et al. The sulfonation of conjugated polymers and sulfonated conjugated polymers, including sulfonated polythiophenes, are described in U.S. Patent No. 8,017,241 to Seshadri et al.

In an embodiment, $R_1$ is $-SO_3M$ and $R_2$ is $-O[C(R_aR_b)-C(R_cR_d)-O]_p-R_e$, or - $OR_f$. In an embodiment, $R_1$ is $-SO_3M$ and $R_2$ is $-O[C(R_aR_b)-C(R_cR_d)-O]_p-R_e$.

In an embodiment, each occurrence of $R_a$, $R_b$, $R_c$, and $R_d$ is each, independently, H, ($C_1$-$C_8$) alkyl, ($C_1$-$C_8$) fluoroalkyl, or phenyl; and $R_e$ and $R_f$ are each, independently, H, ($C_1$-$C_8$) alkyl, ($C_1$-$C_8$) fluoroalkyl, or phenyl.

In an embodiment, $R_2$ is $-O[CH_2-CH_2-O]_p-R_e$. In an embodiment, $R_2$ is - $OR_f$.

Examples of compounds having the formula $-O[C(R_aR_b)-C(R_cR_d)-O]_p-R_e$ or $HOR_f$ that may be converted to a metal salt, typically a sodium salt, and linked to the thiophene monomers to form 3-substituted thiophenes that are then used to produce the polythiophene to be sulfonated include, but are not limited to, trifluoroethanol, ethylene glycol monohexyl ether (hexyl Cellosolve), propylene glycol monobutyl ether (Dowanol PnB), diethylene glycol monoethyl ether (ethyl Carbitol), dipropylene glycol n-butyl ether (Dowanol DPnB), diethylene glycol monophenyl ether (phenyl Carbitol), ethylene glycol monobutyl ether (butyl Cellosolve), diethylene glycol monobutyl ether (butyl Carbitol), dipropylene glycol monomethyl ether (Dowanol DPM), diisobutyl carbinol, 2-ethylhexyl alcohol, methyl isobutyl carbinol, ethylene glycol monophenyl ether (Dowanol Eph), propylene glycol monopropyl ether (Dowanol PnP), propylene glycol monophenyl ether (Dowanol PPh), diethylene glycol monopropyl ether (propyl Carbitol), diethylene glycol monohexyl ether (hexyl Carbitol), 2-ethylhexyl carbitol, dipropylene glycol monopropyl ether (Dowanol DPnP), tripropylene glycol monomethyl ether (Dowanol TPM), diethylene glycol monomethyl ether (methyl Carbitol), and tripropylene glycol monobutyl ether (Dowanol TPnB).

In an embodiment, $R_e$ is H, methyl, propyl, or butyl. In an embodiment, $R_f$ is $-CH_2CF_3$.

In an embodiment, the sulfonated polythiophene is obtained from a polythiophene that comprises a repeating unit

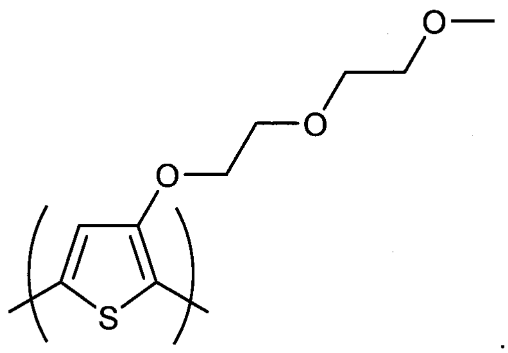

It would be understood by the ordinarily-skilled artisan that the repeating unit

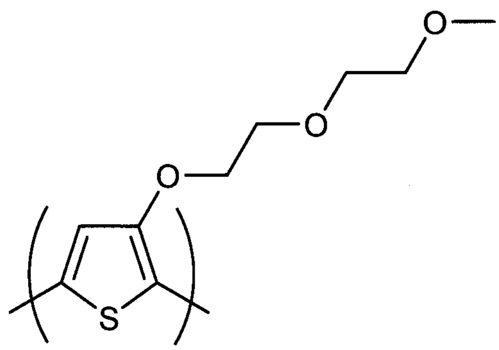

is derived from a monomer represented by the structure

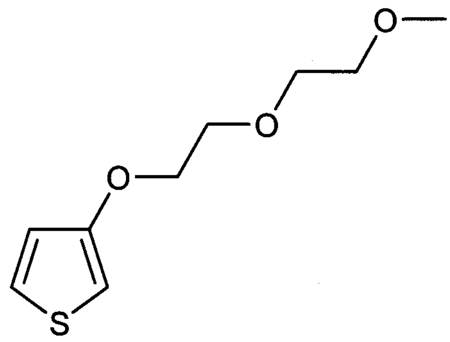

3-(2-(2-methoxyethoxy)ethoxy)thiophene [referred to herein as 3-MEET].

Accordingly, sulfonation of a polythiophene comprising a repeating unit

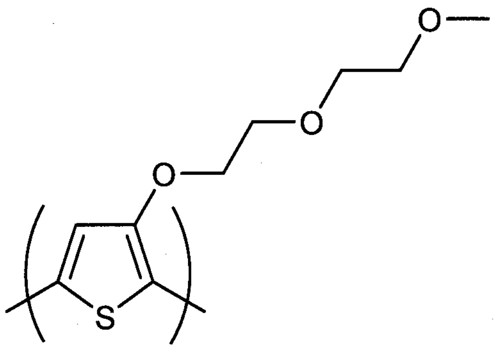

results in sulfonated poly(3-MEET).

In an embodiment, the sulfonated polythiophene is sulfonated poly(3-MEET).

In an embodiment, the sulfonated polythiophene is obtained from a polythiophene that comprises repeating units complying with formula (I) in an amount of greater than 50% by weight, typically greater than 80% by weight, more typically greater than 90% by weight, even more typically greater than 95% by weight, based on the total weight of the repeating units.

It would be clear to a person of ordinary skill in the art that, depending on the purity of the starting monomer compound(s) used to form the conjugated polymer to be sulfonated, the polymer formed may contain repeating units derived from impurities. As used herein, the term "homopolymer" is intended to mean a polymer comprising repeating units derived from one type of monomer, but may contain repeating units derived from impurities. In an embodiment, the sulfonated polythiophene is obtained from a polythiophene that is a homopolymer wherein essentially all of the repeating units are repeating units complying with formula (I).

The sulfonated conjugated polymer is obtained from a conjugated polymer typically having a number average molecular weight between about 1,000 and 1,000,000 g/mol. More typically, the conjugated polymer has a number average molecular weight between about 5,000 and 100,000 g/mol, even more typically about 10,000 to about 50,000 g/mol. Number average molecular weight may be determined according to methods known to those of ordinary skill in the art, such as, for example, by gel permeation chromatography.

In an embodiment, the sulfonated polythiophene may comprise the repeating unit represented by the following formula:

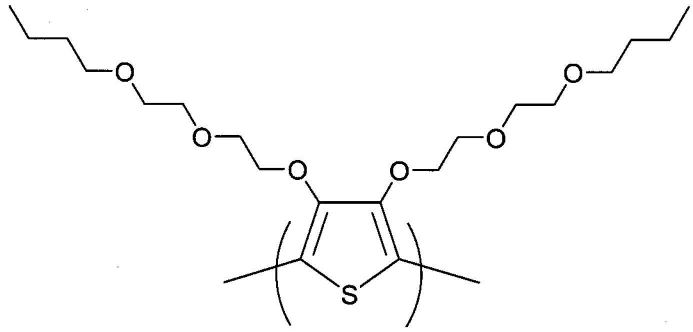
.

Said polythiophene is derived from a monomer represented by the structure of the following formula:

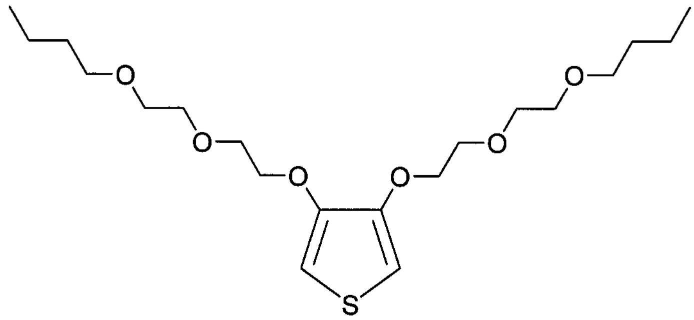
.

3,4-bis(2-(2-butoxyethoxy)ethoxy)thiophene [referred to herein as 3,4-diBEET]

In an embodiment, the sulfonated polythiophene may comprise the repeating unit represented by the following formula:

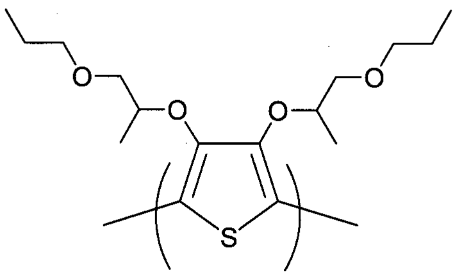
.

Said polythiophene is derived from a monomer represented by the structure of the following formula:

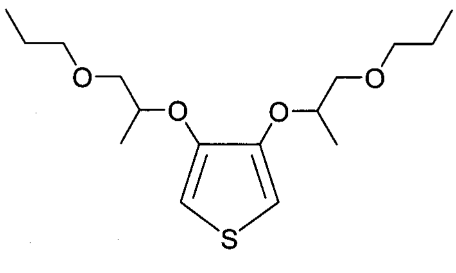
.

3,4-bis((1-propoxypropan-2-yl)oxy)thiophene [referred to herein as 3,4-diPPT]

3,4-disubstituted thiophene monomers, including polymers derived from such monomers, are commercially-available or may be made by methods known to those of ordinary skill in the art. For example, a 3,4-disubstituted thiophene monomer may be produced by reacting 3,4-dibromothiophene with a metal salt, typically the sodium salt, of a compound given by the formula HO-[Z-O]$_p$-R$_e$ or HOR$_f$, wherein Z, R$_e$, R$_f$ and p are as defined herein.

The polymerization of 3,4-disubstituted thiophene monomers may be carried out by, first, brominating the 2

and 5 positions of the 3,4-disubstituted thiophene monomer to form the corresponding 2,5-dibromo derivative of the 3,4-disubstituted thiophene monomer. The polymer can then be obtained by GRIM (Grignard methathesis) polymerization of the 2,5-dibromo derivative of the 3,4-disubstituted thiophene in the presence of a nickel catalyst. Such a method is described, for example, in US Patent 8,865,025, the entirety of which is hereby incorporated by reference. Another known method of polymerizing thiophene monomers is by oxidative polymerization using organic non-metal containing oxidants, such as 2,3-dichloro-5,6-dicyano-1,4-benzoquinone (DDQ), or using a transition metal halide, such as, for example, iron(III) chloride, molybdenum(V) chloride, and ruthenium(III) chloride, as an oxidizing agent.

Examples of compounds having the formula HO-$[Z\text{-}O]_p$-$R_e$ or $HOR_f$ that may be converted to a metal salt, typically a sodium salt, and used to produce 3,4-disubstituted thiophene monomers include, but are not limited to, trifluoroethanol, ethylene glycol monohexyl ether (hexyl Cellosolve), propylene glycol monobutyl ether (Dowanol PnB), diethylene glycol monoethyl ether (ethyl Carbitol), dipropylene glycol n-butyl ether (Dowanol DPnB), diethylene glycol monophenyl ether (phenyl Carbitol), ethylene glycol monobutyl ether (butyl Cellosolve), diethylene glycol monobutyl ether (butyl Carbitol), dipropylene glycol monomethyl ether (Dowanol DPM), diisobutyl carbinol, 2-ethylhexyl alcohol, methyl isobutyl carbinol, ethylene glycol monophenyl ether (Dowanol Eph), propylene glycol monopropyl ether (Dowanol PnP), propylene glycol monophenyl ether (Dowanol PPh), diethylene glycol monopropyl ether (propyl Carbitol), diethylene glycol monohexyl ether (hexyl Carbitol), 2-ethylhexyl carbitol, dipropylene glycol monopropyl ether (Dowanol DPnP), tripropylene glycol monomethyl ether (Dowanol TPM), diethylene glycol monomethyl ether (methyl Carbitol), and tripropylene glycol monobutyl ether (Dowanol TPnB).

In the present invention, the sulfonated conjugated polymer is used after treatment with a reducing agent.

As described above, in sulfonated conjugated polymers such as sulfonated polythiophenes, the chemical structure of some of the repeating units constituting them may be an oxidized structure called a "quinoid structure." The term "quinoid structure" is used as the opposite of the term "benzenoid structure"; whereas the latter is a structure comprising an aromatic ring, the former refers to a structure in which double bond(s) in the aromatic ring have moved out of the ring (as a result of which the aromatic ring disappears), thereby forming two double bonds outside the ring that are conjugated to the other double bond(s) remaining in the ring. Those skilled in the art will readily appreciate the relationship between these two structures from the relationship between the structures of benzoquinone and hydroquinone. The quinoid structures for the repeating units of various sulfonated conjugated polymers are well known to those skilled in the art. As an example, the quinoid structure corresponding to the repeating unit of the sulfonated polythiophene represented by formula (I) above is shown in the following formula (I').

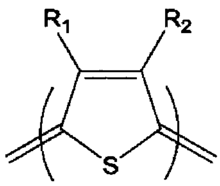

(I')

wherein $R_1$ and $R_2$ are as defined in formula (I).

This quinoid structure forms part of the structures called the "polaron structure" and the "bipolaron structure" that are generated by the doping reaction described above and impart charge transportability to the sulfonated conjugated polymer. These structures are known. The introduction of the "polaron structure" and/or the "bipolaron structure" is essential in the fabrication of an organic EL device, and in fact, this is achieved by intentionally causing the above-mentioned doping reaction to occur when the charge transporting film formed from a charge transporting varnish is baked during the fabrication of an organic EL device. The presence of the quinoid structure in sulfonated conjugated polymers before the doping reaction occurs is believed to be attributable to an unintended oxidation reaction that is equivalent to the doping reaction and is undergone by the sulfonated conjugated polymers in the manufacturing process thereof, in particular, the sulfonation step thereof.

There is a correlation between the amount of quinoid structure contained in a sulfonated conjugated polymer and the dispersibility of the sulfonated conjugated polymer in an organic solvent; as the amount of quinoid structure increases, the dispersibility decreases. Therefore, whereas the introduction of a quinoid structure after the formation of a charge transporting film from the ink composition does not cause a problem, if an excess amount of quinoid structure is introduced into the sulfonated conjugated polymer by the above-mentioned unintended oxidation reaction, it negatively affects the production of the ink composition. It is believed that one of the reasons for the above-discussed variation in the dispersibility in organic solvents of sulfonated conjugated polymers is because the amount of quinoid structure introduced into the polymer by the unintentional oxidation reaction varies depending on the difference in the production conditions for different polymers.

Accordingly, subjecting the sulfonated conjugated polymer to reduction treatment using a reducing agent decreases, through reduction, the amount of quinoid structure, even if there was excessive quinoid structure in the sulfonated conjugated polymer at first. This improves the dispersibility of the sulfonated conjugated polymer in an organic solvent, thereby allowing for stable production of a good ink composition that provides a charge transporting film having excellent homogeneity.

The foregoing was discovered by the present inventors for the first time.

The reducing agent used in this reduction treatment is not particularly limited as long as it can convert the quinoid structure through reduction into a non-oxidized structure, i.e., the benzenoid structure (for example, in the sulfonated polythiophene represented by formula (I) above, the quinoid structure represented by formula (I') above is converted into the structure represented by formula (I) above), and for example, ammonia water, hydrazine, or the like are preferably used. The amount of reducing agent is typically from 0.1 to 10 parts by weight, preferably from 0.5 to 2 parts by weight, based on 100 parts by weight of the sulfonated conjugated polymer to be treated.

There are no particular restrictions on the method and conditions for the reduction treatment. This treatment can be carried out, for example, simply by contacting the sulfonated conjugated polymer with a reducing agent in the presence or absence of a suitable solvent. Typically, reduction treatment under relatively mild conditions, such as stirring the sulfonated conjugated polymer in 28% aqueous ammonia (e.g., overnight at room temperature), substantially improves the dispersibility of the sulfonated conjugated polymer in an organic solvent.

If necessary, the sulfonated conjugated polymer may be converted to a corresponding ammonium salt, e.g., a trialkylammonium salt (an amine adduct of the sulfonated polythiophene) prior to subjecting it to reduction treatment.

A sulfonated conjugated polymer that was not dissolved in the reaction system at the start of the treatment may be dissolved at the completion of the treatment, as a result of a change in the dispersibility of the sulfonated conjugated polymer in the solvent caused by the reduction treatment. In such cases, the sulfonated conjugated polymer can be recovered, for example, by adding an organic solvent incompatible with the sulfonated conjugated polymer (such as acetone, isopropyl alcohol, etc., if the sulfonated conjugated polymer is a sulfonated polythiophene) to the reaction system to cause precipitation of the sulfonated conjugated polymer before subjecting it to filtration.

The ink composition of the present invention may optionally further comprise other hole carrier compounds.

Optional hole carrier compounds include, for example, low molecular weight compounds or high molecular weight compounds. The optional hole carrier compounds may be non-polymeric or polymeric. Non-polymeric hole carrier compounds include, but are not limited to, cross-linkable and non-crosslinked small molecules. Examples of non-polymeric hole carrier compounds include, but are not limited to, N,N'-bis(3-methylphenyl)-N,N'-bis(phenyl)benzidine (CAS # 65181-78-4); N,N'-bis(4-methylphenyl)-N,N'-bis(phenyl)benzidine; N,N'-bis(2-naphtalenyl)-N-N'-bis(phenylbenzidine) (CAS # 139255-17-1); 1,3,5-tris(3-methyldiphenylamino)benzene (also referred to as m-MTDAB); N,N'-bis(1-naphtalenyl)-N,N'-bis(phenyl)benzidine (CAS # 123847-85-8, NPB); 4,4',4''-tris(N,N-phenyl-3-methylphenylamino)triphenylamine (also referred to as m-MTDATA, CAS # 124729-98-2); 4,4',N,N'-diphenylcarbazole (also referred to as CBP, CAS # 58328-31-7); 1,3,5-tris(diphenylamino)benzene; 1,3,5-tris(2-(9-ethylcarbazyl-3)ethylene)benzene; 1,3,5-tris[(3-methylphenyl)phenylamino]benzene; 1,3-bis(N-carbazolyl)benzene; 1,4-bis(diphenylamino)benzene; 4,4'-bis(N-carbazolyl)-1,1'-biphenyl; 4,4'-bis(N-carbazolyl)-1,1'-biphenyl; 4-(dibenzylamino)benzaldehyde-N,N-diphenylhydrazone; 4-(diethylamino)benzaldehyde diphenylhydrazone; 4-(dimethylamino)benzaldehyde diphenylhydrazone; 4-(diphenylamino)benzaldehyde diphenylhydrazone; 9-ethyl-3-carbazolecarboxaldehyde diphenylhydrazone; copper(II) phthalocyanine; N,N'-bis(3-methylphenyl)-N,N'-diphenylbenzidine; N,N'-di-[(1-naphthyl)-N,N'-diphenyl]-1,1'-biphenyl)-4,4'-diamine; N,N'-diphenyl-N,N'-di-p-tolylbenzene-1,4-diamine; tetra-N-phenylbenzidine; titanyl phthalocyanine; tri-p-tolylamine; tris(4-carbazol-9-ylphenyl)amine; and tris[4-(diethylamino)phenyl]amine.

Optional polymeric hole carrier compounds include, but are not limited to, poly[(9,9-dihexylfluorenyl-2,7-diyl)-alt-co-(N,N'-bis{p-butylphenyl}-1,4-diaminophenylene)]; poly[(9,9-dioctylfluorenyl-2,7-diyl)-alt-co-(N,N'-bis{p-butylphenyl}-1,1'-biphenylene-4,4'-diamine)]; poly(9,9-dioctylfluorene-co-N-(4-butylphenyl)diphenylamine) (also referred to as TFB) and poly[N,N'-bis(4-butylphenyl)-N,N'-bis(phenyl)-benzidine] (commonly referred to as poly-TPD).

Other optional hole carrier compounds are described in, for example, US Patent Publications 2010/0292399 published Nov. 18, 2010; 2010/010900 published May 6, 2010; and 2010/ 0108954 published May 6, 2010. Optional hole carrier compounds described herein are known in the art and are commercially available.

The polythiophene comprising a repeating unit complying with formula (I) may be doped or undoped.

In an embodiment, the polythiophene comprising a repeating unit complying with formula (I) is doped with a dopant. Dopants are known in the art. See, for example, U.S. Patent 7,070,867; US Publication 2005/0123793; and US Publication 2004/0113127. The dopant can be an ionic compound. The dopant can comprise a cation and an anion. One or more dopants may be used to dope the polythiophene comprising a repeating unit complying with formula (I).

The cation of the ionic compound can be, for example, V, Cr, Mn, Fe, Co, Ni, Cu, Nb, Mo, Tc, Ru, Rh, Pd, Ag, Ta, W, Re, Os, Ir, Pt, or Au.

The cation of the ionic compound can be, for example, gold, molybdenum, rhenium, iron, and silver cation.

In some embodiments, the dopant can comprise a sulfonate or a carboxylate, including alkyl, aryl, and heteroaryl sulfonates and carboxylates. As used herein, "sulfonate" refers to a $-SO_3M$ group, wherein M may be $H^+$ or an alkali

metal ion, such as, for example, $Na^+$, $Li^+$, $K^+$, $Rb^+$, $Cs^+$; or ammonium ($NH_4^+$). As used herein, "carboxylate" refers to a $-CO_2M$ group, wherein M may be $H^+$ or an alkali metal ion, such as, for example, $Na^+$, $Li^+$, $K^+$, $Rb^+$, $Cs^+$; or ammonium ($NH_4^+$). Examples of sulfonate and carboxylate dopants include, but are not limited to, benzoate compounds, heptafluorobutyrate, methanesulfonate, trifluoromethanesulfonate, p-toluenesulfonate, pentafluoropropionate, and polymeric sulfonates, perfluorosulfonate-containing ionomers, and the like.

In some embodiments, the dopant does not comprise a sulfonate or a carboxylate.

In some embodiments, dopants may comprise sulfonylimides, such as, for example, bis(trifluoromethanesulfonyl)imide; antimonates, such as, for example, hexafluoroantimonate; arsenates, such as, for example, hexafluoroarsenate; phosphorus compounds, such as, for example, hexafluorophosphate; and borates, such as, for example, tetrafluoroborate, tetraarylborates, and trifluoroborates. Examples of tetraarylborates include, but are not limited to, halogenatedtetraarylborates, such as tetrakispentafluorophenylborate (TPFB). Examples of trifluoroborates include, but are not limited to, (2-nitrophenyl)trifluoroborate, benzofurazan-5-trifluoroborate, pyrimidine-5-trifluoroborate, pyridine-3-trifluoroborate, and 2,5-dimethylthiophene-3-trifluoroborate.

As disclosed herein, the polythiophene can be doped with a dopant. A dopant can be, for example, a material that will undergo one or more electron transfer reaction(s) with, for example, a conjugated polymer, thereby yielding a doped polythiophene. The dopant can be selected to provide a suitable charge balancing counter-anion. A reaction can occur upon mixing of the polythiophene and the dopant as known in the art. For example, the dopant may undergo spontaneous electron transfer from the polymer to a cation-anion dopant, such as a metal salt, leaving behind a conjugated polymer in its oxidized form with an associated anion and free metal. See, for example, Lebedev et al., Chem. Mater., 1998, 10, 156-163. As disclosed herein, the polythiophene and the dopant can refer to components that will react to form a doped polymer. The doping reaction can be a charge transfer reaction, wherein charge carriers are generated, and the reaction can be reversible or irreversible. In some embodiments, silver ions may undergo electron transfer to or from silver metal and the doped polymer.

In the final formulation, the composition can be distinctly different from the combination of original components (i.e., polythiophene and/or dopant may or may not be present in the final composition in the same form as before mixing).

Some embodiments allow for removal of reaction by-products from the doping process. For example, the metals, such as silver, can be removed by filtrations.

Materials can be purified to remove, for example, halogens and metals. Halogens include, for example, chloride, bromide and iodide. Metals include, for example, the cation of the dopant, including the reduced form of the cation of the dopant, or metals left from catalyst or initiator residues. Metals include, for example, silver, nickel, and magnesium. The amounts can be less than, for example, 100 ppm, or less than 10 ppm, or less than 1 ppm.

Metal content, including silver content, can be measured by ICP-MS, particularly for concentrations greater than 50 ppm.

In an embodiment, when the polythiophene is doped with a dopant, the polythiophene and the dopant are mixed to form a doped polymer composition. Mixing may be achieved using any method known to those of ordinary skill in the art. For example, a solution comprising the polythiophene may be mixed with a separate solution comprising the dopant. The solvent or solvents used to dissolve the polythiophene and the dopant may be one or more solvents described herein. A reaction can occur upon mixing of the polythiophene and the dopant as known in the art. The resulting doped polythiophene composition comprises between about 40% and 75% by weight of the polymer and between about 25% and 55% by weight of the dopant, based on the composition. In another embodiment, the doped polythiophene composition comprises between about 50% and 65% for the polythiophene and between about 35% and 50% of the dopant, based on the composition. Typically, the amount by weight of the polythiophene is greater than the amount by weight of the dopant. Typically, the dopant can be a silver salt, such as silver tetrakis(pentafluorophenyl)borate in an amount of about 0.25 to 0.5 m/ru, wherein m is the molar amount of silver salt and ru is the molar amount of polymer repeat unit.

The doped polythiophene is isolated according to methods known to those of ordinary skill in the art, such as, for example, by rotary evaporation of the solvent, to obtain a dry or substantially dry material, such as a powder. The amount of residual solvent can be, for example, 10 wt. % or less, or 5 wt. % or less, or 1 wt. % or less, based on the dry or substantially dry material. The dry or substantially dry powder can be redispersed or redissolved in one or more new solvents.

The ink composition of the present invention comprises one or more amine compounds.

Amine compounds suitable for use in the ink compositions of the present invention include, but are not limited to, ethanolamines and alkylamines.

Examples of suitable ethanolamines include dimethylethanol amine [$(CH_3)_2NCH_2CH_2OH$], triethanol amine [$N(CH_2CH_2OH)_3$], and N-tert-butyldiethanolamine [$t\text{-}C_4H_9N(CH_2CH_2OH)_2$].

Alkylamines include primary, secondary, and tertiary alkylamines. Examples of primary alkylamines include, for example, ethylamine [$C_2H_5NH_2$], n-butylamine [$C_4H_9NH_2$], t-butylamine [$C_4H_9NH_2$], n-hexylamine [$C_6H_{13}NH_2$], 2-ethylhexylamine [$C_8H_{17}NH_2$], n-decylamine [$C_{10}H_{21}NH_2$], and ethylenediamine [$H_2NCH_2CH_2NH_2$]. Secondary alkylamines include, for example, diethylamine [$(C_2H_5)_2NH$], di(n-propylamine) [$(n\text{-}C_3H_9)_2NH$], di(isopropylamine)[(i-

$C_3H_9)_2NH$], and dimethyl ethylenediamine [$CH_3NHCH_2CH_2NHCH_3$]. Tertiary alkylamines include, for example, trimethylamine [$(CH_3)_3N$], triethylamine [$(C_2H_5)_3N$], tri(n-butyl)amine [$(C_4H_9)_3N$], and tetramethyl ethylenediamine [$(CH_3)_2NCH_2CH_2N(CH_3)_2$].

In some embodiments, the amine compound is a tertiary alkylamine. In an embodiment, the amine compound is triethylamine.

In some embodiments, the amine compound is a mixture of a tertiary alkylamine compound and an amine compound other than a tertiary alkylamine compound. In an embodiment, the amine compound other than a tertiary alkylamine compound is a primary alkylamine compound. For the primary alkylamine compound, 2-ethylhexylamine or n-butylamine is preferable, and 2-ethylhexylamine is more preferable.

The amount of the amine compound can be adjusted and measured as a weight percentage relative to the total amount of the ink composition. In an embodiment, the amount of the amine compound is at least 0.01 wt. %, at least 0.10 wt. %, at least 1.00 wt. %, at least 1.50 wt. %, or at least 2.00 wt. %, with respect to the total amount of the ink composition. In an embodiment, the amount of the amine compound is from about 0.01 wt. % to about 2.00 wt. %, typically from about 0.05 wt. % to about 1.50 wt. %, more typically from about 0.1 wt. % to about 1.0 wt. %, with respect to the total amount of the ink composition. At least a portion of the amine compound may be present in the form of an ammonium salt, e.g., a trialkylammonium salt, of the sulfonated conjugated polymer (an amine adduct of the sulfonated polythiophene).

This amine compound is added typically at the time of preparing the final ink composition, but may be added in advance at an earlier point in time. For example, as described above, the amine compound may be added to the sulfonated conjugated polymer, thereby converting it to the corresponding ammonium salt, e.g., a trialkylammonium salt (an amine adduct of the sulfonated polythiophene), followed by reduction treatment. Alternatively, the amine compound (e.g., triethylamine) may be added to a solution of a sulfonated conjugated polymer that has undergone reduction treatment, and the sulfonated conjugated polymer may be precipitated as an ammonium salt (e.g., a triethylammonium salt) in powder form, which can be recovered.

Although there is no particular limitation on the method of such treatment, exemplary methods include the following: the sulfonated polythiophene that has been subjected to reduction treatment is dissolved by adding to it water and triethylamine, the mixture is stirred under heating (for example, at 60°C), and then isopropyl alcohol and acetone are added to the obtained solution to cause precipitation of the triethylammonium salt of the sulfonated conjugated polymer, which is filtered and recovered.

The ink composition of the present invention optionally comprises one or more metal oxide nanoparticles.

As used herein, "metalloid" refers to an element having chemical and/or physical properties intermediate of, or that are a mixture of, those of metals and nonmetals. Herein, "metalloid" refers to boron (B), silicon (Si), germanium (Ge), arsenic (As), antimony (Sb), and tellurium (Te).

As used herein, "metal oxide" refers to an oxide of one or a combination of two or more selected from metals such as tin (Sn), titanium (Ti), aluminum (Al), zirconium (Zr), zinc (Zn), niobium (Nb), tantalum (Ta), and W (tungsten), and the above-mentioned metalloids.

As used herein, the term "nanoparticle" refers to a nanoscale particle, the primary particle average diameter of which is typically 500 nm or less. For the primary particle average diameter, for example, transmission electron microscopy (TEM) or a method of converting from the specific surface area by the BET method can be used.

In the method of measuring particle diameter by TEM, particle diameter can be measured by processing a projected image of nanoparticles using image processing software, and then obtaining the area-equivalent diameter (which is defined as the diameter of a circle having the same area as a nanoparticle). Typically, the processing of projected images is carried out using image processing software that is produced by the TEM manufacturer and distributor and is provided with the TEM (e.g., the transmission electron microscope HT7700, available from Hitachi High Technologies, Inc.). The average particle diameter can be obtained as the number average of circle-equivalent diameters.

The primary particle average diameter of the metal oxide nanoparticles described herein is less than or equal to 500 nm; less than or equal to 250 nm; less than or equal to 100 nm; or less than or equal to 50 nm; or less than or equal to 25 nm. Typically, the metal oxide nanoparticles have a number average particle diameter from about 1 nm to about 100 nm, more typically from about 2 nm to about 30 nm.

Metal oxide nanoparticles suitable for use according to the present invention include oxides of boron (B), silicon (Si), germanium (Ge), arsenic (As), antimony (Sb), tellurium (Te), tin (Sn), titanium (Ti), aluminum (Al), zirconium (Zr), zinc (Zn), niobium (Nb), tantalum (Ta), and W (tungsten), etc., or mixed oxides containing these. Non-limiting specific examples of suitable metal oxide nanoparticles include, but are not limited to, nanoparticles comprising $B_2O_3$, $B_2O$, $SiO_2$, SiO, $GeO_2$, GeO, $As_2O_4$, $As_2O_3$, $As_2O_5$, $Sb_2O_3$, $Sb_2O_5$, $TeO_2$, $SnO_2$, $ZrO_2$, $Al_2O_3$, ZnO and mixtures thereof.

In an embodiment, the ink composition of the present invention comprises one or more metal oxide nanoparticles comprising $B_2O_3$, $B_2O$, $SiO_2$, SiO, $GeO_2$, GeO, $As_2O_4$, $As_2O_3$, $As_2O_5$, $SnO_2$, SnO, $Sb_2O_3$, $TeO_2$, or mixtures thereof.

In an embodiment, the ink composition of the present invention comprises one or more metal oxide nanoparticles comprising $SiO_2$.

The metal oxide nanoparticles may comprise one or more organic capping groups. Such organic capping groups may be reactive or non-reactive. Reactive organic capping groups are organic capping groups capable of cross-linking, for example, in the presence of UV radiation or radical initiators.

In an embodiment, the metal oxide nanoparticles comprise one or more organic capping groups.

Examples of suitable metal oxide nanoparticles include $SiO_2$ nanoparticles available as dispersions in various solvents, such as, for example, methyl ethyl ketone, methyl isobutyl ketone, N,N-dimethylacetamide, ethylene glycol, isopropanol, methanol, ethylene glycol monopropyl ether, and propylene glycol monomethyl ether acetate, marketed as ORGANOSILICASOL™ by Nissan Chemical.

The amount of the metal oxide nanoparticles used in the ink composition described herein can be controlled and measured as a weight percentage relative to the combined weight of the metal oxide nanoparticles and the doped or undoped polythiophene. In an embodiment, the amount of the metal oxide nanoparticles is from 1 wt. % to 98 wt. %, typically from about 2 wt. to about 95 wt. %, more typically from about 5 wt. % to about 90 wt. %, still more typically about 10 wt. % to about 90 wt. %, relative to the combined weight of the metal oxide nanoparticles and the doped or undoped polythiophene. In an embodiment, the amount of the metal oxide nanoparticles is from about 20 wt. % to about 98 wt. %, typically from about 25 wt. to about 95 wt. %, relative to the combined weight of the metal oxide nanoparticles and the doped or undoped polythiophene.

The ink composition of the present invention may optionally further comprise one or more matrix compounds known to be useful in hole injection layers (HILs) or hole transport layers (HTLs).

The optional matrix compound can be a lower or higher molecular weight compound, and is different from the polythiophene described herein. The matrix compound can be, for example, a synthetic polymer that is different from the polythiophene. See, for example, US Patent Publication No. 2006/0175582 published Aug. 10, 2006. The synthetic polymer can comprise, for example, a carbon backbone. In some embodiments, the synthetic polymer has at least one polymer side group comprising an oxygen atom or a nitrogen atom. The synthetic polymer may be a Lewis base. Typically, the synthetic polymer comprises a carbon backbone and has a glass transition temperature of greater than 25 °C. The synthetic polymer may also be a semi-crystalline or crystalline polymer that has a glass transition temperature equal to or lower than 25 °C and/or a melting point greater than 25 °C. The synthetic polymer may comprise one or more acidic groups, for example, sulfonic acid groups.

In an embodiment, the synthetic polymer is a polymeric acid comprising one or more repeating units comprising at least one alkyl or alkoxy group which is substituted by at least one fluorine atom and at least one sulfonic acid ($-SO_3H$) moiety, wherein said alkyl or alkoxy group is optionally interrupted by at least one ether linkage (-O-) group.

In an embodiment, the polymeric acid comprises a repeating unit complying with formula (II) and a repeating unit complying with formula (III)

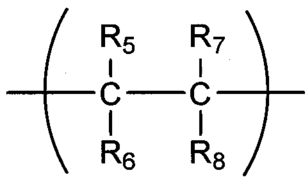

(II)

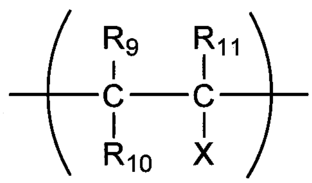

(III)

wherein each occurrence of $R_5$, $R_6$, $R_7$, $R_8$, $R_9$, $R_{10}$, and $R_{11}$ is, independently, H, halogen, fluoroalkyl, or perfluoroalkyl; and X is $-[OC(R_hR_i)-C(R_jR_k)]_q-O-[CR_lR_m]_z-SO_3H$, wherein each occurrence of $R_h$, $R_i$, $R_j$, $R_k$, $R_l$ and $R_m$ is, independently, H, halogen, fluoroalkyl, or perfluoroalkyl; q is 0 to 10; and z is 1 to 5.

In an embodiment, each occurrence of $R_5$, $R_6$, $R_7$, and $R_8$ is, independently, Cl or F. In an embodiment, each occurrence of $R_5$, $R_7$, and $R_8$ is F, and $R_6$ is Cl. In an embodiment, each occurrence of $R_5$, $R_6$, $R_7$, and $R_8$ is F.

In an embodiment, each occurrence of $R_9$, $R_{10}$, and $R_{11}$ is F.

In an embodiment, each occurrence of $R_h$, $R_i$, $R_j$, $R_k$, $R_l$ and $R_m$ is, independently, F, ($C_1$-$C_8$) fluoroalkyl, or ($C_1$-$C_8$) perfluoroalkyl.

In an embodiment, each occurrence of $R_l$ and $R_m$ is F; q is 0; and z is 2.

In an embodiment, each occurrence of $R_5$, $R_7$, and $R_8$ is F, and $R_6$ is Cl; and each occurrence of $R_l$ and $R_m$ is F; q is 0; and z is 2.

In an embodiment, each occurrence of $R_5$, $R_6$, $R_7$, and $R_8$ is F; and each occurrence of $R_l$ and $R_m$ is F; q is 0; and z is 2.

The ratio of the number of repeating units complying with formula (II) ("n") to the number of the repeating units complying with formula (III) ("m") is not particularly limited. The n:m ratio is typically from 9:1 to 1:9, more typically 8:2 to 2:8. In an embodiment, the n:m ratio is 9:1. In an embodiment, the n:m ratio is 8:2.

The polymeric acid suitable for use according to the present invention may be synthesized using methods known to those of ordinary skill in the art or obtained from commercially-available sources. For instance, the polymers comprising a repeating unit complying with formula (II) and a repeating unit complying with formula (III) may be made by co-polymerizing monomers represented by formula (IIa) with monomers represented by formula (IIIa)

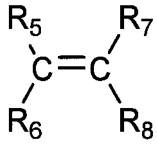 (IIa)

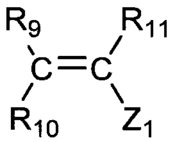 (IIIa)

wherein $Z_1$ is $-[OC(R_hR_i)-C(R_jR_k)]_q-O-[CR_lR_m]_z-SO_2F$, wherein $R_h$, $R_i$, $R_j$, $R_k$, $R_l$ and $R_m$, q, and z are as defined herein, according to known polymerization methods, followed by conversion to sulfonic acid groups by hydrolysis of the sulfonyl fluoride groups.

For example, tetrafluoroethylene (TFE) or chlorotrifluoroethylene (CTFE) may be copolymerized with one or more fluorinated monomers comprising a precursor group for sulfonic acid, such as, for example, $F_2C=CF-O-CF_2-CF_2-SO_2F$; $F_2C=CF-[O-CF_2-CR_{12}F-O]_q-CF_2-CF_2-SO_2F$, wherein $R_{12}$ is F or $CF_3$ and q is 1 to 10; $F_2C=CF-O-CF_2-CF_2-CF_2-SO_2F$; and $F_2C=CF-OCF_2-CF_2-CF_2-CF_2-SO_2F$.

The equivalent weight of the polymeric acid is defined as the mass, in grams, of the polymeric acid per mole of acidic groups present in the polymeric acid. The equivalent weight of the polymeric acid is from about 400 to about 15,000 g polymer/mol acid, typically from about 500 to about 10,000 g polymer/mol acid, more typically from about 500 to 8,000 g polymer/mol acid, even more typically from about 500 to 2,000 g polymer/mol acid, still more typically from about 600 to about 1,700 g polymer/mol acid.

Such polymeric acids are, for instance, those marketed by E. I. DuPont under the trade name NAFION®, those marketed by Solvay Specialty Polymers under the trade name AQUIVION®, or those marketed by Asahi Glass Co. under the trade name FLEMION®.

In an embodiment, the synthetic polymer is a polyether sulfone comprising one or more repeating units comprising at least one sulfonic acid ($-SO_3H$) moiety.

In an embodiment, the polyether sulfone comprises a repeating unit complying with formula (IV)

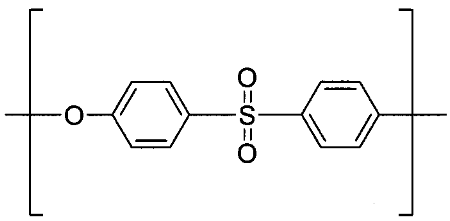 (IV)

and a repeating unit selected from the group consisting of a repeating unit complying with formula (V) and a repeating unit complying with formula (VI)

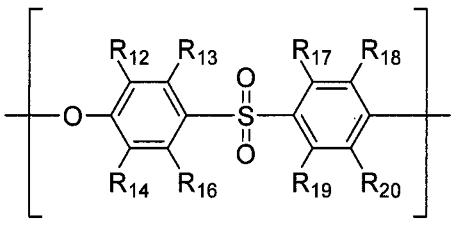

(V)

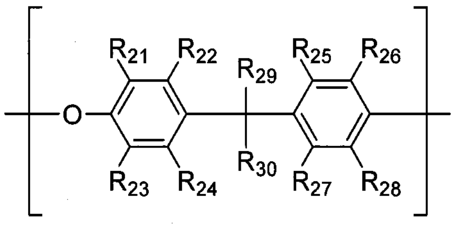

(VI)

wherein $R_{12}$-$R_{20}$ are each, independently, H, halogen, alkyl, or $SO_3H$, provided that at least one of $R_{12}$-$R_{20}$ is $SO_3H$; and wherein $R_{21}$-$R_{28}$ are each, independently, H, halogen, alkyl, or $SO_3H$, provided that at least one of $R_{21}$-$R_{28}$ is $SO_3H$, and $R_{29}$ and $R_{30}$ are each H or alkyl.

In an embodiment, $R_{29}$ and $R_{30}$ are each alkyl. In an embodiment, $R_{29}$ and $R_{30}$ are each methyl.

In an embodiment, $R_{12}$-$R_{17}$, $R_{19}$, and $R_{20}$, are each H and $R_{18}$ is $SO_3H$.

In an embodiment, $R_{21}$-$R_{25}$, $R_{27}$, and $R_{28}$, are each H and $R_{26}$ is $SO_3H$.

In an embodiment, the polyether sulfone is represented by formula (VII)

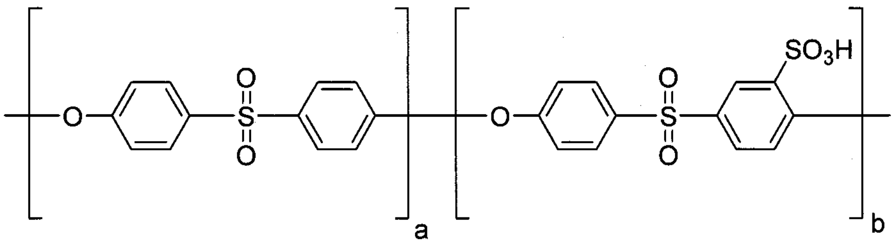

(VII)

wherein a is from 0.7 to 0.9 and b is from 0.1 to 0.3.

The polyether sulfone may further comprise other repeating units, which may or may not be sulfonated.

For example, the polyether sulfone may comprise a repeating unit of formula (VIII)

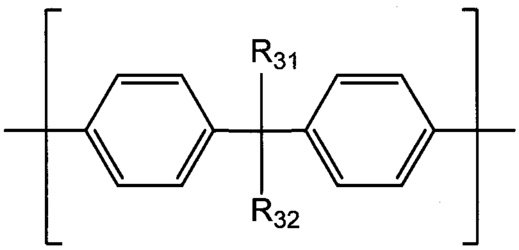

(VIII)

wherein $R_{31}$ and $R_{32}$ are each, independently, H or alkyl.

Any two or more repeating units described herein may together form a repeating unit and the polyether sulfone may comprise such a repeating unit. For example, the repeating unit complying with formula (IV) may be combined with a repeating unit complying with formula (VI) to give a repeating unit complying with formula (IX)

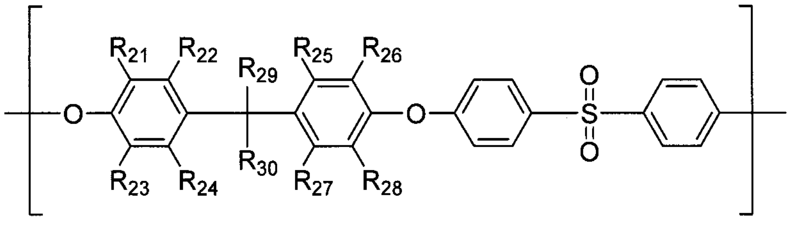

(IX).

Analogously, for example, the repeating unit complying with formula (IV) may be combined with a repeating unit complying with formula (VIII) to give a repeating unit complying with formula (X)

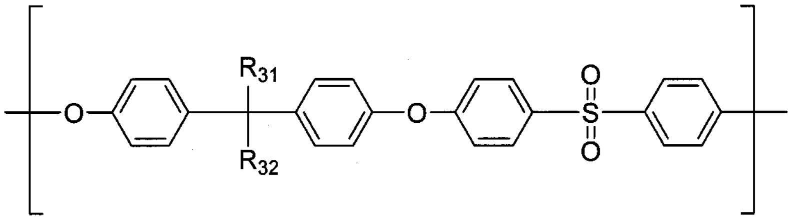

(X).

In an embodiment, the polyether sulfone is represented by formula (XI)

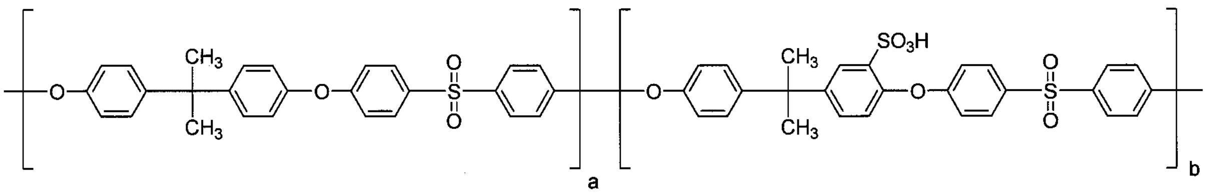

(XI)

wherein a is from 0.7 to 0.9 and b is from 0.1 to 0.3.

Polyether sulfones comprising one or more repeating units comprising at least one sulfonic acid ($-SO_3H$) moiety are commercially-available, for example, sulfonated polyether sulfones marketed as S-PES by Konishi Chemical Ind.Co., Ltd.

The optional matrix compound can be a planarizing agent. A matrix compound or a planarizing agent may be comprised of, for example, a polymer or oligomer such as an organic polymer, such as poly(styrene) or poly(styrene) derivatives; poly(vinyl acetate) or derivatives thereof; poly(ethylene glycol) or derivatives thereof; poly(ethylene-co-vinyl acetate); poly(pyrrolidone) or derivatives thereof (e.g., poly(1-vinylpyrrolidone-co-vinyl acetate)); poly(vinyl pyridine) or derivatives thereof; poly(methyl methacrylate) or derivatives thereof; poly(butyl acrylate); poly(aryl ether ketones); poly(aryl sulfones); poly(esters) or derivatives thereof; or combinations thereof.

In an embodiment, the matrix compound is poly(styrene) or a poly(styrene) derivative.

In an embodiment, the matrix compound is poly(4-hydroxystyrene).

The optional matrix compound or planarizing agent may be comprised of, for example, at least one semiconducting matrix component. The semiconducting matrix component is different from the polythiophene described herein. The semiconducting matrix component can be a semiconducting small molecule or a semiconducting polymer that is typically comprised of repeat units comprising hole carrying units in the main-chain and/or in a side-chain. The semiconducting matrix component may be in the neutral form or may be doped, and is typically soluble and/or dispersible in organic solvents, such as toluene, chloroform, acetonitrile, cyclohexanone, anisole, chlorobenzene, o-dichlorobenzene, ethyl benzoate and mixtures thereof.

The amount of the optional matrix compound can be controlled and measured as a weight percentage relative to the amount of the doped or undoped polythiophene. In an embodiment, the amount of the optional matrix compound is from 0 to 99.5 wt. %, typically from about 10 wt. to about 98 wt. %, more typically from about 20 wt. % to about 95 wt. %, still more typically about 25 wt. % to about 45 wt. %, relative to the amount of the doped or undoped polythiophene. In the embodiment with 0 wt. %, the ink composition is free of matrix compound.

The liquid carrier used in the ink composition according to the present invention comprises one or more organic solvents. In an embodiment, the ink composition consists essentially of or consists of one or more organic solvents. The liquid carrier may be an organic solvent or solvent blend comprising two or more organic solvents adapted for use and processing with other layers in a device such as the anode or light emitting layer.

Organic solvents suitable for use in the liquid carrier include, but are not limited to, aliphatic and aromatic ketones, organosulfur solvents, such as dimethyl sulfoxide (DMSO) and 2,3,4,5-tetrahydrothiophene-1,1-dioxide (tetramethylene sulfone; Sulfolane), tetrahydrofuran (THF), tetrahydropyran (THP), tetramethyl urea (TMU), *N*,*N*'-dimethylpropyleneurea, alkylated benzenes, such as xylene and isomers thereof, halogenated benzenes, N-methylpyrrolidinone (NMP), dimethylformamide (DMF), dimethylacetamide (DMAc), dichloromethane, acetonitrile, dioxanes, ethyl acetate, ethyl benzoate, methyl benzoate, dimethyl carbonate, ethylene carbonate, propylene carbonate, 3-methoxypropionitrile, 3-ethoxypropionitrile, or combinations thereof.

Aliphatic and aromatic ketones include, but are not limited to, acetone, acetonyl acetone, methyl ethyl ketone (MEK), methyl isobutyl ketone, methyl isobutenyl ketone, 2-hexanone, 2-pentanone, acetophenone, ethyl phenyl ketone, cyclohexanone, and cyclopentanone. In some embodiments, ketones with protons on the carbon located alpha to the ketone are avoided, such as cyclohexanone, methyl ethyl ketone, and acetone.

Other organic solvents might also be considered that solubilize, completely or partially, the polythiophene polymer or that swell the polythiophene polymer. Such other solvents may be included in the liquid carrier in varying quantities to modify ink properties such as wetting, viscosity, morphology control. The liquid carrier may further comprise one or more organic solvents that act as non-solvents for the polythiophene polymer.

Other organic solvents suitable for use according to the present invention include ethers such as anisole, ethoxybenzene, dimethoxy benzenes and glycol diethers (glycol diethers), such as, ethylene glycol diethers (such as 1,2-dimethoxyethane, 1,2-diethoxyethane, and 1,2-dibutoxyethane); diethylene glycol diethers such as diethylene glycol dimethyl ether, and diethylene glycol diethyl ether; propylene glycol diethers such as propylene glycol dimethyl ether, propylene glycol diethyl ether, and propylene glycol dibutyl ether; dipropylene glycol diethers, such as dipropylene glycol dimethyl ether, dipropylene glycol diethyl ether, and dipropylene glycol dibutyl ether; as well as higher analogues (i.e., tri- and tetra- analogues, e.g., triethylene glycol dimethyl ether, triethylene glycol butyl methyl ether, tetraethylene glycol dimethyl ether, etc.) of the ethylene glycol and propylene glycol ethers mentioned herein.

Still other solvents can be considered, such as ethylene glycol monoether acetates and propylene glycol monoether acetates (glycol ester ethers), wherein the ether can be selected, for example, from methyl, ethyl, n-propyl, isopropyl, n-butyl, sec-butyl, tert-butyl, and cyclohexyl; as well as higher glycol ether analogues of the above list (such as di-, tri- and tetra-).

Examples include, but are not limited to, propylene glycol methyl ether acetate, 2-ethoxyethyl acetate, 2-butoxyethyl acetate, ethylene glycol monomethyl ether acetate, and diethylene glycol monomethyl ether acetate.

Still other solvents such as ethylene glycol diacetate (glycol diesters) can be considered, which include higher glycol ether analogues (such as di-, tri- and tetra-).

Examples include, but are not limited to, ethylene glycol diacetate, triethylene glycol diacetate, and propylene glycol diacetate.

Alcohols may also be considered for use in the liquid carrier, such as, for example, methanol, ethanol, trifluoroethanol, n-propanol, isopropanol, n-butanol, t-butanol, and and alkylene glycol monoethers (glycol monoethers). Examples of suitable glycol monoethers include, but are not limited to, ethylene glycol monopropyl ether, ethylene glycol monohexyl ether (hexyl Cellosolve), propylene glycol monobutyl ether (Dowanol PnB), diethylene glycol monoethyl ether (ethyl Carbitol), dipropylene glycol n-butyl ether (Dowanol DPnB), ethylene glycol monobutyl ether (butyl Cellosolve), diethylene glycol monobutyl ether (butyl Carbitol), dipropylene glycol monomethyl ether (Dowanol DPM), diisobutyl carbinol, 2-ethylhexyl alcohol, methyl isobutyl carbinol, propylene glycol monopropyl ether (Dowanol PnP), diethylene glycol monopropyl ether (propyl Carbitol), diethylene glycol monohexyl ether (hexyl Carbitol), 2-ethylhexyl carbitol, dipropylene glycol monopropyl ether (Dowanol DPnP), tripropylene glycol monomethyl ether (Dowanol TPM), diethylene glycol monomethyl ether (methyl Carbitol), and tripropylene glycol monobutyl ether (Dowanol TPnB).

As disclosed herein, the organic solvents disclosed herein can be used in varying proportions in the liquid carrier, for example, to improve ink characteristics such as substrate wettability, ease of solvent removal, viscosity, surface tension, and jettability.

In some embodiments, the use of aprotic non-polar solvents can provide the additional benefit of increased life-times for devices with emitter technologies which are sensitive to protons, such as, for example, PHOLEDs.

In an embodiment, the liquid carrier comprises dimethyl sulfoxide, ethylene glycol (glycols), tetramethyl urea, or a mixture thereof.

Examples of suitable glycols include, but are not limited to, ethylene glycol, diethylene glycol, dipropylene glycol, polypropylene glycol, propylene glycol, triethylene glycol, and the like.

The above-mentioned glycol diethers, glycol ester ethers, glycol diesters, glycol monoethers, glycol monoethers, glycols, and the like are collectively referred to as "glycol-based solvents". That is, a "glycol-based solvent" as used

herein is an organic solvent that does not have one or more aromatic structures and is represented by the formula $R^1$-O-(R-O)$_n$-$R^2$, wherein each R is, independently, a linear $C_2$-$C_4$ unsubstituted alkylene group; $R^1$ and $R^2$ are each, independently, a hydrogen atom, a linear, branched, or cyclic $C_1$-$C_8$ unsubstituted alkyl group, or a linear or branched $C_1$-$C_8$ unsubstituted aliphatic acyl group; and n is an integer of 1 to 6. It is particularly preferable that R is a $C_2$ or $C_3$ unsubstituted alkylene group. It is particularly preferable that n is an integer of 1 to 4. As the alkyl group, a linear, branched or cyclic $C_1$-$C_6$ unsubstituted alkyl group is preferable, a linear $C_1$-$C_4$ unsubstituted alkyl group is more preferable, and a methyl group and an n-butyl group are particularly preferable. As the acyl group, a linear or branched $C_2$-$C_6$ unsubstituted aliphatic acyl group is preferable, a linear $C_2$-$C_4$ unsubstituted acyl group is more preferable, and an acetyl group and a propionyl group are particularly preferable. Such glycol-based solvents include, for example, the following solvents.

- Glycols which are ethylene glycol, propylene glycol or oligomers thereof (dimers to tetramers, e.g. diethylene glycol)
- Glycol monoethers which are monoalkyl ethers of the aforementioned glycols
- Glycol diethers which are dialkyl ethers of the aforementioned glycols
- Glycol monoesters which are aliphatic carboxylic acid monoesters of the aforementioned glycols
- Glycol diesters which are aliphatic carboxylic acid diesters of the aforementioned glycols
- Glycol ester ethers which are aliphatic carboxylic acid monoesters of the aforementioned glycol monoethers

For ease of application by ink-jet coating, it is preferable to use a liquid carrier comprising a glycol-based solvent.

Hereinafter, glycol-based solvents may be contrasted with organic solvents not falling under this category, and, for convenience, the former may be denoted by (A) and the latter may be denoted by (B).

In an embodiment, the liquid carrier is a liquid carrier consisting of one or more glycol-based solvents (A).

In an embodiment, the liquid carrier is a liquid carrier comprising one or more glycol-based solvents (A) and one or more organic solvents other than glycol-based solvents (B).

Preferable examples of glycol-based solvents (A) include glycol diethers, glycol monoethers, and glycols, as well as mixtures thereof. Examples include, but are not limited to, mixtures of glycol diethers and glycols. Specific examples include the above-mentioned examples of glycol diethers and glycols, and preferable examples of glycol diethers include triethylene glycol dimethyl ether and triethylene glycol butyl methyl ether, and preferable examples of glycols include ethylene glycol and diethylene glycol.

Preferable examples of organic solvents (B) include nitriles, alcohols, aromatic ethers, and aromatic hydrocarbons.

Examples of nitriles include, but are not limited to, methoxypropionitrile and ethoxypropionitrile. Examples of alcohols include, but are not limited to, benzyl alcohol, and 2-(benzyloxy)ethanol. Examples of aromatic ethers include, but are not limited to, methyl anisole, dimethyl anisole, ethyl anisole, butyl phenyl ether, butyl anisole, pentyl anisole, hexyl anisole, heptyl anisole, octyl anisole, phenoxy toluene. Examples of aromatic hydrocarbons include, but are not limited to, pentylbenzene, hexylbenzene, heptylbenzene, octylbenzene, nonylbenzene, cyclohexylbenzene, and tetralin.

Among these, alcohols are more preferable, and 2-(benzyloxy)ethanol is more preferable among the alcohols.

In the case of using metal oxide nanoparticles, addition of an organic solvent (B) to a glycol-based solvent (A) allows proper control, at the time of film formation by ink-jet coating, of the aggregation of the metal oxide nanoparticles while maintaining the solubility of the solids in the ink, thereby enabling a flatter film to be formed.

When the organic solvent (B) is added to the glycol-based solvent (A), the amount of glycol-based solvent (A): wtA (in weight) and the amount of organic solvent (B): wtB (in weight) preferably satisfy formula (1-1), more preferably satisfy formula (1-2), and most preferably satisfy formula (1-3).

$$0.05 \leq \mathrm{wtB} / (\mathrm{wtA} + \mathrm{wtB}) \leq 0.50 \qquad (1\text{-}1)$$

$$0.10 \leq \mathrm{wtB} / (\mathrm{wtA} + \mathrm{wtB}) \leq 0.40 \qquad (1\text{-}2)$$

$$0.15 \leq \mathrm{wtB} / (\mathrm{wtA} + \mathrm{wtB}) \leq 0.30 \qquad (1\text{-}3)$$

Where the composition of the present invention comprises two or more glycol-based solvents (A), wtA indicates the total amount (in weight) of glycol-based solvents (A); where the composition of the present invention comprises two or more organic solvents (B), wtB indicates the total amount (in weight) of organic solvents (B).

The amount of liquid carrier in the ink composition according to the present invention is from about 50 wt. % to about 99 wt. %, typically from about 75 wt. % to about 98 wt. %, still more typically from about 90 wt. % to about 95

wt. %, with respect to the total amount of ink composition.

The total solids content (% TS) in the ink composition according to the present invention is from about 0.1 wt. % to about 50 wt. %, typically from about 0.3 wt. % to about 40 wt. %, more typically from about 0.5 wt. % to about 15 wt. %, still more typically from about 1 wt. % to about 5 wt. %, with respect to the total amount of ink composition.

The ink compositions described herein may be prepared according to any suitable method known to the ordinarily-skilled artisan. For example, in one method, an initial aqueous mixture is prepared by mixing an aqueous dispersion of the polythiophene described herein with an aqueous dispersion of polymeric acid, if desired, another matrix compound, if desired, and additional solvent. The solvents, including water, in the mixture are then removed, typically by evaporation. The resulting dry product is then dissolved or dispersed in one or more organic solvents, such as dimethyl sulfoxide, and filtered under pressure to yield a non-aqueous mixture. An amine compound may optionally be added to such non-aqueous mixture. The non-aqueous mixture is then mixed with a non-aqueous dispersion of the metal oxide nanoparticles to yield the final non-aqueous ink composition.

In another method, the ink compositions described herein may be prepared from stock solutions. For example, a stock solution of the polythiophene described herein can be prepared by isolating the polythiophene in dry form from an aqueous dispersion, typically by evaporation. The dried polythiophene is then combined with one or more organic solvents and, optionally, an amine compound. If desired, a stock solution of the polymeric acid described herein can be prepared by isolating the polymeric acid in dry form from an aqueous dispersion, typically by evaporation. The dried polymeric acid is then combined with one or more organic solvents. Stock solutions of other optional matrix materials can be made analogously. Stock solutions of the metal oxide nanoparticles can be made, for example, by diluting commercially-available dispersions with one or more organic solvents, which may be the same or different from the solvent or solvents contained in the commercial dispersion. Desired amounts of each stock solution are then combined to form the ink compositions of the present invention.

Still in another method, the ink compositions described herein may be prepared by isolating the individual components in dry form as described herein, but instead of preparing stock solutions, the components in dry form are combined and then dissolved in one or more organic solvents to provide the NQ ink composition.

The ink composition according to the present invention can be cast and annealed as a film on a substrate.

Thus, the present invention also relates to a process for forming a hole-carrying film, the process comprising:

1) coating a substrate with an ink composition disclosed herein; and
2) annealing the coating on the substrate, thereby forming the hole-carrying film.

The coating of the ink composition on a substrate can be carried out by methods known in the art including, for example, spin casting, spin coating, dip casting, dip coating, slot-dye coating, ink jet printing, gravure coating, doctor blading, and any other methods known in the art for fabrication of, for example, organic electronic devices.

The substrate can be flexible or rigid, organic or inorganic. Suitable substrate compounds include, for example, glass, including, for example, display glass, ceramic, metal, and plastic films.

As used herein, the term "annealing" refers to any general process for forming a hardened layer, typically a film, on a substrate coated with the ink composition of the present invention. General annealing processes are known to those of ordinary skill in the art. Typically, the solvent is removed from the substrate coated with the ink composition. The removal of solvent may be achieved, for example, by subjecting the coated substrate to pressure less than atmospheric pressure, and/or by heating the coating layered on the substrate to a certain temperature (annealing temperature), maintaining the temperature for a certain period of time (annealing time), and then allowing the resulting layer, typically a film, to slowly cool to room temperature.

The step of annealing can be carried out by heating the substrate coated with the ink composition using any method known to those of ordinary skill in the art, for example, by heating in an oven or on a hot plate. Annealing can be carried out under an inert environment, for example, nitrogen atmosphere or noble gas atmosphere, such as, for example, argon gas. Annealing may be carried out in air atmosphere.

In an embodiment, the annealing temperature is from about 25 °C to about 350 °C, typically from about 150 °C to about 325 °C, more typically from about 200 °C to about 300 °C, still more typically from about 230 °C to about 300 °C.

The annealing time is the time for which the annealing temperature is maintained. The annealing time is from about 3 to about 40 minutes, typically from about 15 to about 30 minutes.

In an embodiment, the annealing temperature is from about 25 °C to about 350 °C, typically from about 150 °C to about 325 °C, more typically from about 200 °C to about 300 °C, still more typically from about 250 °C to about 300 °C, and the annealing time is from about 3 to about 40 minutes, typically for about 15 to about 30 minutes.

The present invention relates to the hole-carrying film formed by the process described herein.

Transmission of visible light is important, and good transmission (low absorption) at higher film thicknesses is particularly important. For example, the film made according to the process of the present invention can exhibit a transmittance (typically, with a substrate) of at least about 85%, typically at least about 90%, of light having a wavelength

of about 380-800 nm. In an embodiment, the transmittance is at least about 90%.

In one embodiment, the film made according to the process of the present invention has a thickness of from about 5 nm to about 500 nm, typically from about 5 nm to about 150 nm, more typically from about 50 nm to 120 nm.

In an embodiment, the film made according to the process of the present invention exhibits a transmittance of at least about 90% and has a thickness of from about 5 nm to about 500 nm, typically from about 5 nm to about 150 nm, more typically from about 50 nm to 120 nm. In an embodiment, the film made according to the process of the present invention exhibits a transmittance (%T) of at least about 90% and has a thickness of from about 50 nm to 120 nm.

The films made according to the processes of the present invention may be made on a substrate optionally containing an electrode or additional layers used to improve electronic properties of a final device. The resulting films may be intractable to one or more organic solvents, which can be the solvent or solvents used as liquid carrier in the ink for subsequently coated or deposited layers during fabrication of a device. The films may be intractable to, for example, toluene, which can be the solvent in the ink for subsequently coated or deposited layers during fabrication of a device.

The present invention also relates to a device comprising a film prepared according to the processes described herein. The devices described herein can be made by methods known in the art including, for example, solution processing. Inks can be applied and solvents removed by standard methods. The film prepared according to the processes described herein may be an HIL and/or HTL layer in the device.

Methods are known in the art and can be used to fabricate organic electronic devices including, for example, OLED and OPV devices. Methods known in the art can be used to measure brightness, efficiency, and lifetimes. Organic light emitting diodes (OLED) are described, for example, in U.S. Patents 4,356,429 and 4,539,507 (Kodak). Conducting polymers which emit light are described, for example, in U.S. Patents 5,247,190 and 5,401,827 (Cambridge Display Technologies). Device architecture, physical principles, solution processing, multilayering, blends, and compounds synthesis and formulation are described in Kraft et al., "Electroluminescent Conjugated Polymers-Seeing Polymers in a New Light," Angew. Chem. Int. Ed., 1998, 37, 402-428, which is hereby incorporated by reference in its entirety.

Light emitters known in the art and commercially available can be used including various conducting polymers as well as organic molecules, such as compounds available from Sumation, Merck Yellow, Merck Blue, American Dye Sources (ADS), Kodak (e.g., AlQ3 and the like), and even Aldrich, such as BEHP-PPV. Examples of such organic electroluminescent compounds include:

(i) poly(p-phenylene vinylene) and its derivatives substituted at various positions on the phenylene moiety;

(ii) poly(p-phenylene vinylene) and its derivatives substituted at various positions on the vinylene moiety;

(iii) poly(p-phenylene vinylene) and its derivatives substituted at various positions on the phenylene moiety and also substituted at various positions on the vinylene moiety;

(iv) poly(arylene vinylene), where the arylene may be such moieties as naphthalene, anthracene, furylene, thienylene, oxadiazole, and the like;

(v) derivatives of poly(arylene vinylene), where the arylene may be as in (iv) above, and additionally have substituents at various positions on the arylene;

(vi) derivatives of poly(arylene vinylene), where the arylene may be as in (iv) above, and additionally have substituents at various positions on the vinylene;

(vii) derivatives of poly(arylene vinylene), where the arylene may be as in (iv) above, and additionally have substituents at various positions on the arylene and substituents at various positions on the vinylene;

(viii) co-polymers of arylene vinylene oligomers, such as those in (iv), (v), (vi), and (vii) with non-conjugated oligomers; and

(ix) poly(p-phenylene) and its derivatives substituted at various positions on the phenylene moiety, including ladder polymer derivatives such as poly(9,9-dialkyl fluorene) and the like;

(x) poly(arylenes) where the arylene may be such moieties as naphthalene, anthracene, furylene, thienylene, oxadiazole, and the like; and their derivatives substituted at various positions on the arylene moiety;

(xi) co-polymers of oligoarylenes, such as those in (x) with non-conjugated oligomers;

(xii) polyquinoline and its derivatives;

(xiii) co-polymers of polyquinoline with p-phenylene substituted on the phenylene with, for example, alkyl or alkoxy groups to provide solubility; and

(xiv) rigid rod polymers, such as poly(p-phenylene-2,6-benzobisthiazole), poly(p-phenylene-2,6-benzobisoxazole), poly(p-phenylene-2,6-benzimidazole), and their derivatives;

(xv) polyfluorene polymers and co-polymers with polyfluorene units.

Preferred organic emissive polymers include SUMATION Light Emitting Polymers ("LEPs") that emit green, red, blue, or white light or their families, copolymers, derivatives, or mixtures thereof; the SUMATION LEPs are available from Sumation KK. Other polymers include polyspirofluorene-like polymers available from Covion Organic Semiconductors GmbH, Frankfurt, Germany (now owned by Merck®).

Alternatively, rather than polymers, small organic molecules that emit by fluorescence or by phosphorescence can serve as the organic electroluminescent layer. Examples of small-molecule organic electroluminescent compounds include: (i) tris(8-hydroxyquinolinato) aluminum (Alq); (ii) 1,3-bis(N,N-dimethylaminophenyl)-1,3,4-oxidazole (OXD-8); (iii) -oxo-bis(2-methyl-8-quinolinato)aluminum; (iv) bis(2-methyl-8-hydroxyquinolinato) aluminum; (v) bis(hydroxybenzoquinolinato) beryllium ($BeQ_2$); (vi) bis(diphenylvinyl)biphenylene (DPVBI); and (vii) arylamine-substituted distyrylarylene (DSA amine).

Such polymer and small-molecule compounds are well known in the art and are described in, for example, U.S. Patent 5,047,687.

The devices can be fabricated in many cases using multilayered structures which can be prepared by, for example, solution or vacuum processing, as well as printing and patterning processes. In particular, use of the embodiments described herein for hole injection layers (HILs), wherein the composition is formulated for use as a hole injection layer, can be carried out effectively.

Examples of HIL in devices include:

1) Hole injection in OLEDs including PLEDs and SMOLEDs; for example, for HIL in PLED, all classes of conjugated polymeric emitters where the conjugation involves carbon or silicon atoms can be used. For HIL in SMOLED, the following are examples: SMOLED containing fluorescent emitters; SMOLED containing phosphorescent emitters; SMOLEDs comprising one or more organic layers in addition to the HIL layer; and SMOLEDs where the small molecule layer is processed from solution or aerosol spray or any other processing methodology. In addition, other examples include HIL in dendrimer or oligomeric organic semiconductor based OLEDs; HIL in ambipolar light emitting FET's where the HIL is used to modify charge injection or as an electrode;

2) Hole extraction layer in OPV;

3) Channel material in transistors;

4) Channel material in circuits comprising a combination of transistors, such as logic gates;

5) Electrode material in transistors;

6) Gate layer in a capacitor;

7) Chemical sensor where modification of doping level is achieved due to association of the species to be sensed with the conductive polymer;

8) Electrode or electrolyte material in batteries.

A variety of photoactive layers can be used in OPV devices. Photovoltaic devices can be prepared with photoactive layers comprising fullerene derivatives mixed with, for example, conducting polymers as described in, for example, U.S. Patents 5,454,880; 6,812,399; and 6,933,436. Photoactive layers may comprise blends of conducting polymers, blends of conducting polymers and semiconducting nanoparticles, and bilayers of small molecules such as phthalocyanines, fullerenes, and porphyrins.

Common electrode compounds and substrates, as well as encapsulating compounds can be used.

In one embodiment, the cathode comprises Au, Ca, Al, Ag, or combinations thereof. In one embodiment, the

anode comprises indium tin oxide. In one embodiment, the light emission layer comprises at least one organic compound.

Interfacial modification layers, such as, for example, interlayers, and optical spacer layers may be used.

Electron transport layers can be used.

The present invention also relates to a method of making a device described herein.

In an embodiment, the method of making a device comprises: providing a substrate; layering a transparent conductor, such as, for example, indium tin oxide, on the substrate; providing the ink composition described herein; layering the ink composition on the transparent conductor to form a hole injection layer or hole transport layer; layering an active layer on the hole injection layer or hole transport layer (HTL); and layering a cathode on the active layer.

As described herein, the substrate can be flexible or rigid, organic or inorganic. Suitable substrate compounds include, for example, glass, ceramic, metal, and plastic films.

In another embodiment, a method of making a device comprises applying the ink composition as described herein as part of an HIL or HTL layer in an OLED, a photovoltaic device, an ESD, a SMOLED, a PLED, a sensor, a supercapacitor, a cation transducer, a drug release device, an electrochromic device, a transistor, a field effect transistor, an electrode modifier, an electrode modifier for an organic field transistor, an actuator, or a transparent electrode.

The layering of the ink composition to form the HIL or HTL layer can be carried out by methods known in the art including, for example, spin casting, spin coating, dip casting, dip coating, slot-dye coating, ink jet printing, gravure coating, doctor blading, and any other methods known in the art for fabrication of, for example, organic electronic devices.

In one embodiment, the HIL layer is thermally annealed. In one embodiment, the HIL layer is thermally annealed at temperature of about 25 °C to about 350 °C, typically 150 °C to about 325 °C. In one embodiment, the HIL layer is thermally annealed at temperature of of about 25 °C to about 350 °C, typically 150 °C to about 325 °C, for about 3 to about 40 minutes, typically for about 15 to about 30 minutes.

In accordance with the present invention, an HIL or HTL can be prepared that can exhibit a transmittance (typically, with a substrate) of at least about 85%, typically at least about 90%, of light having a wavelength of about 380-800 nm. In an embodiment, the transmittance is at least about 90%.

In one embodiment, the HIL layer has a thickness of from about 5 nm to about 500 nm, typically from about 5 nm to about 150 nm, more typically from about 50 nm to 120 nm.

In an embodiment, the HIL layer exhibits a transmittance of at least about 90% and has a thickness of from about 5 nm to about 500 nm, typically from about 5 nm to about 150 nm, more typically from about 50 nm to 120 nm. In an embodiment, the HIL layer exhibits a transmittance (%T) of at least about 90% and has a thickness of from about 50 nm to 120 nm.

The inks, methods and processes, films, and devices according to the present invention are further illustrated by the following non-limiting examples.

**Examples**

The components used in the following examples are summarized in Table 1 below.

Table 1.

| | |
|---|---|
| S-poly(3-MEET) | Sulfonated poly(3-MEET) |
| TFE-VEFS 1 | TFE/perfluoro-2-(vinyloxy)ethane-1-sulfonic acid copolymer having equivalent weight of 676 g polymer/mol acid (available from Solvay as AQUIVION® D66-20BS); n:m = 8:2 |
| EG-ST | 20-21 wt. % silica dispersion in ethylene glycol (ORGANOSILICASOL™ EG-ST, available from Nissan Chemical) |
| Ammonia water | 28% Ammonia water |
| 2-EHA | 2-Ethylhexylamine |
| BA | n-Butylamine |
| EG | Ethylene glycol |
| DEG | Diethylene glycol |
| TEGDME | Triethylene glycol dimethyl ether |
| 2-BOE | 2-(Benzyloxy)ethanol |

### (1) Preparation of charge transporting materials

### Production Example 1

Preparation of amine adduct of S-poly(3-MEET)

A preparation was made by mixing 500 g of an aqueous dispersion of S-poly(3-MEET) (0.598% solids in water) with 0.858 g of triethylamine. The resulting mixture was dried by rotary evaporation and then further dried in a vacuum oven at 50°C overnight. The product was isolated as 3.8 g of a black powder.

### Example 1

2.00 g of the amine adduct of S-poly(3-MEET) obtained in Production Example 1 was dissolved in 100 ml of 28% ammonia water (manufactured by Junsei Chemical Co., Ltd.) and stirred at room temperature overnight. The reaction solution was reprecipitated with 1500 mL of acetone, and the precipitate was collected by filtration. The obtained precipitate was dissolved again in 20 mL of water and 7.59 g of triethylamine (manufactured by Tokyo Chemical Industries Co., Ltd.) and stirred at 60°C for 1 hour. After the reaction solution was cooled, it was reprecipitated with a mixed solvent of 1000 mL of isopropyl alcohol and 500 mL of acetone, and the precipitate was collected by filtration. The obtained precipitate was dried in vacuo (0 mmHg) at 50°C for 1 hour to obtain 1.30 g of S-poly(3-MEET)-A, which was a charge transporting material treated with aqueous ammonia.

### (2) Preparation of charge transporting varnishes

### Example 2

First, an aqueous solution D66-20BS was evaporated using an evaporator, and the resultant residue was dried at 80°C for 1 hour under reduced pressure using a vacuum drier, to obtain a powder of D66-20BS. The obtained powder was used to prepare a 10 wt. % solution of D66-20BS in ethylene glycol. This solution was prepared using a hot stirrer and stirred at 400 rpm at 90°C for 1 hour.

Next, another vessel was provided, and 0.030 g of S-poly(3-MEET)-A, which was the charge transporting material obtained in Example 1, was dissolved in 1.77 g of ethylene glycol (manufactured by Kanto Chemical Co., Ltd.), 4.83 g of triethylene glycol dimethyl ether (manufactured by Tokyo Chemical Industry Co., Ltd.), 1.93 g of 2-(benzyloxy)ethanol (manufactured by Kanto Chemical Co., Ltd.), and 0.049 g of 2-ethylhexylamine (manufactured by Tokyo Chemical Industry Co., Ltd.). The solution was prepared using a hot stirrer and stirred at 80°C for 1 hour. Then, 0.15 g of a 2 wt. % ethylene glycol solution of D66-20BS was added thereto, and the mixture was stirred for 1 hour at 400 rpm at 80°C using a hot stirrer. Finally, 1.24 g of EG-ST was added, and stirred using a hot stirrer at 400 rpm at 80°C for 10 minutes, and the resulting solution was filtered through a PP syringe filter (pore size: 0.2 μm) to yield a 3 wt. % charge transporting varnish.

### Example 3

First, an aqueous solution D66-20BS was evaporated using an evaporator, and the resultant residue was dried at 80°C for 1 hour under reduced pressure using a vacuum drier, to obtain a powder of D66-20BS. The obtained powder was used to prepare a 10 wt. % solution of D66-20BS in ethylene glycol. This solution was prepared using a hot stirrer and stirred at 400 rpm at 90°C for 1 hour.

Next, another vessel was provided, and 0.030 g of S-poly(3-MEET)-A, which was the charge transporting material obtained in Example 1, was dissolved in 0.32 g of ethylene glycol (manufactured by Kanto Chemical Co., Ltd.), 1.45 g of diethylene glycol (manufactured by Kanto Chemical Co., Ltd.), 4.83 g of triethylene glycol dimethyl ether (manufactured by Tokyo Chemical Industry Co., Ltd.), 1.93 g of 2-(benzyloxy) ethanol (manufactured by Kanto Chemical Co., Ltd.) and 0.049 g of 2-ethylhexylamine (manufactured by Tokyo Chemical Industry Co., Ltd.). The solution was prepared using a hot stirrer and stirred at 80°C for 1 hour. Then, 0.15 g of a 2 wt. % ethylene glycol solution of D66-20BS was added thereto, and the mixture was stirred for 1 hour at 400 rpm at 80°C using a hot stirrer. Finally, 1.24 g of EG-ST was added, and stirred using a hot stirrer at 400 rpm at 80°C for 10 minutes, and the resulting solution was filtered through a PP syringe filter (pore size: 0.2 μm) to yield a 3 wt. % charge transporting varnish.

### Example 4

A charge transporting varnish was obtained in the same manner as in Example 3 except that n-butylamine

(manufactured by Tokyo Chemical Industry Co., Ltd.) was used instead of 2-ethylhexylamine, used in Example 3.

**(3) Production and characterization of organic EL devices**

**Examples 5-1, 5-2, and 5-3**

The varnishes obtained in Examples 2, 3, and 4 were each applied to an ITO substrate using a spin coater, and then dried at 120°C under air atmosphere for 1 minute. Next, the dried ITO substrates were baked at 200°C under air atmosphere for 15 minutes to form films, 50 nm thick, on the ITO substrates. For the ITO substrates, glass substrates (25 mm × 25 mm × 0.7 t) on the surface of which indium tin oxide (ITO) was patterned to a thickness of 150 nm were used, and the impurities on the surface of the glass substrates were removed by an $O_2$ plasma cleaning device (150 W, 30 seconds) prior to use.

Next, α-NPD (N,N'-di(1-naphthyl)-N,N'-diphenylbenzidine) was deposited using an vacuum evaporator (degree of vacuum: $1.0\times10^{-5}$ Pa) to a thickness of 30 nm at a rate of 0.2 nm/sec on the ITO substrates on which the films were formed. Next, an another film of HTEB-01 (an electron blocking material manufactured by Kanto Chemical Co., Ltd.) was formed having a thickness of 10 nm. Then, NS60 (a host material for the light emitting layer manufactured by Nippon Steel & Sumikin Chemical Co., Ltd.) and $Ir(PPy)_3$ (a dopant material for the light emitting layer) were co-deposited. In this co-deposition process, the deposition rate was controlled so that the concentration of $Ir(PPy)_3$ was 6%, and the layer was deposited to a thickness of 40 nm. Next, films of $Alq_3$, lithium fluoride and aluminum were successively laminated to obtain an organic electroluminescent device. In these steps, the deposition rates were set to 0.2 nm/sec for Alq3, 0.2 nm/sec for aluminum, and 0.02 nm/sec for lithium fluoride and the film thicknesses were set to 20 nm, 0.5 nm, and 80 nm, respectively.

In order to prevent characteristic deterioration under the influence of oxygen, water, and the like in the air, the organic EL devices were sealed using sealing substrates before the characteristics thereof were evaluated. Sealing was performed by the following procedure. The organic EL devices were placed between sealing substrates in a nitrogen atmosphere having an oxygen concentration of 2 ppm or less and a dew point of -76°C or less, and the sealing substrates were bonded to each other using an adhesive (Moresco Moisture Cut WB90US (P), manufactured by MORESCO Corporation). In this step, a water-trapping agent (HD-071010W-40, manufactured by Dynic Corporation) was placed between the sealing substrates together with the organic EL device, and the sealing substrates stuck together were irradiated with UV light (wavelength: 365 nm, irradiation level: 6,000 mJ/cm$^2$), and then annealed at 80°C for 1 hour to cure the adhesive.

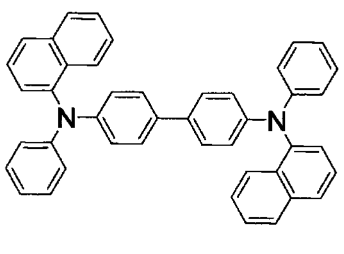

NPB

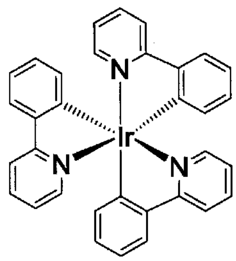

$Ir(PPy)_3$

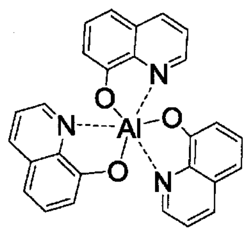

$Alq_3$

The devices of Examples 4-1 and 4-2 were driven at a luminance of 5000 cd/m$^2$, and the drive voltage, current density, and luminous efficacy, and luminance half-life (time elapsed before luminance from an initial value of 5000 cd/m$^2$ reaches half the initial value) were measured. The results are shown in Table 2.

Table 2

| Example no. | Drive voltage (V) | Current density (mA/cm$^2$) | Current efficiency (cd/A) | External quantum efficiency (%) | Luminance half-life (h) |
|---|---|---|---|---|---|
| 5-1 | 5.4 | 9.1 | 55.0 | 15.7 | 1545.7 |
| 5-2 | 5.3 | 8.4 | 59.6 | 17.1 | 1880.8 |
| 5-3 | 5.8 | 9.0 | 55.4 | 15.8 | 1728.6 |

## Claims

1. An ink composition comprising:

   (a) a sulfonated conjugated polymer obtained by treating with a reducing agent a sulfonated conjugated polymer comprising a repeating unit having a quinoid structure;
   (b) at least one amine compound; and
   (c) a liquid carrier comprising at least one organic solvent.

2. The ink composition according to claim 1, wherein the reducing agent is ammonia or hydrazine.

3. The ink composition according to claim 1 or 2, wherein the amine compound comprises a tertiary alkylamine compound and an amine compound other than a tertiary alkylamine compound.

4. The ink composition according to claim 3, wherein the amine compound other than a tertiary alkylamine compound is a primary alkylamine compound.

5. The ink composition according to claim 4, wherein the primary alkylamine compound is at least one selected from the group consisting of ethylamine, n-butylamine, t-butylamine, n-hexylamine, 2-ethylhexylamine, n-decylamine, and ethylenediamine.

6. The ink composition according to claim 5, wherein the primary alkylamine compound is 2-ethylhexylamine or n-butylamine.

7. The ink composition according to any one of claims 1 to 6, wherein the sulfonated conjugated polymer is a sulfonated polythiophene.

8. The ink composition according to claim 7, wherein the sulfonated polythiophene is a sulfonated polythiophene comprising a repeating unit complying with formula (I):

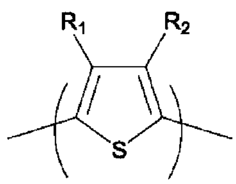

**(I)**

wherein $R_1$ and $R_2$ are each, independently, H, alkyl, fluoroalkyl, alkoxy, aryloxy, or $-O-[Z-O]_p-R_e$;
wherein

   Z is an optionally halogenated hydrocarbylene group,
   p is equal to or greater than 1, and
   $R_e$ is H, alkyl, fluoroalkyl, or aryl;

provided that either $R_1$ or $R_2$ is $-SO_3M$, wherein M is H, an alkali-metal ion, ammonium, a monoalkylammonium, a dialkylammonium, or a trialkylammonium.

9. The ink composition according to claim 8, wherein $R_1$ and $R_2$ are each, independently, H, fluoroalkyl, $-O[C(R_aR_b)-C(R_cR_d)-O]_p-R_e$, $-OR_f$; wherein each occurrence of $R_a$, Rb, $R_c$, and $R_d$ is each, independently, H, alkyl, fluoroalkyl, or aryl; $R_e$ is H, alkyl, fluoroalkyl, or aryl; p is 1, 2, or 3; and $R_f$ is alkyl, fluoroalkyl, or aryl.

10. The ink composition according to claim 8, wherein $R_1$ is $-SO_3M$ and $R_2$ is other than $-SO_3M$.

11. The ink composition according to claim 10, wherein $R_1$ is $-SO_3M$ and $R_2$ is - $O[C(R_aR_b)-C(R_cR_d)-O]_p-R_e$, or $-OR_f$.

12. The ink composition according to claim 11, wherein $R_1$ is $-SO_3M$ and $R_2$ is - $O[C(R_aR_b)-C(R_cR_d)-O]_p-R_e$.

**13.** The ink composition according to claim 12, wherein $R_1$ is $-SO_3M$ and $R_2$ is $-O-CH_2CH_2-O-CH_2CH_2-O-CH_3$.

**14.** The ink composition according to any one of claims 8 to 13, wherein the sulfonated polythiophene is sulfonated poly(3-MEET).

**15.** The ink composition according to any one of claims 8 to 14, wherein the sulfonated polythiophene is obtained by sulfonation of a polythiophene comprising repeating units complying with formula (I) in an amount of greater than 70% by weight, typically greater than 80% by weight, more typically greater than 90% by weight, even more typically greater than 95% by weight, based on the total weight of the repeating units.

**16.** The ink composition according to any one of claims 1 to 15, wherein the liquid carrier is a liquid carrier comprising at least one glycol-based solvent (A) and at least one organic solvent (B) other than a glycol-based solvent.

**17.** The ink composition according to claim 16, wherein the glycol-based solvent (A) is a glycol ether, a glycol monoether, or a glycol.

**18.** The ink composition according to claim 16 or 17, wherein the organic solvent (B) is a nitrile, an alcohol, an aromatic ether, or an aromatic hydrocarbon.

**19.** The ink composition according to any one of claims 16 to 18, wherein the amount of glycol-based solvent (A): wtA (in weight) and the amount of organic solvent (B) (in weight): wtB (in weight) satisfy formula (1-1).

$$0.05 \leq wtB / (wtA + wtB) \leq 0.50 \qquad (1\text{-}1)$$

**20.** The ink composition according to any one of claims 1 to 19, wherein the non-aqueous ink composition further comprises one or more metal oxide nanoparticles.

**21.** The ink composition according to claim 20, wherein the metal oxide nanoparticles comprise $B_2O_3$, $B_2O$, $SiO_2$, $SiO$, $GeO_2$, $GeO$, $As_2O_4$, $As_2O_3$, $As_2O_5$, $Sb_2O_3$, $TeO_2$, $SnO_2$, $SnO$, or mixtures thereof.

**22.** The ink composition according to claim 21, wherein the metal oxide nanoparticles comprise $SiO_2$.

**23.** The ink composition according to any one of claims 1 to 22, wherein the non-aqueous ink composition further comprises a synthetic polymer comprising one or more acidic groups.

**24.** The ink composition according to claim 23, wherein the synthetic polymer is a polymeric acid comprising one or more repeating units comprising at least one alkyl or alkoxy group substituted by at least one fluorine atom and at least one sulfonic acid ($-SO_3H$) moiety, wherein said alkyl or alkoxy group is optionally interrupted by at least one ether linking (-O-) group.

**25.** The ink composition according to claim 24, wherein the polymeric acid comprises a repeating unit complying with formula (II) and a repeating unit complying with formula (III):

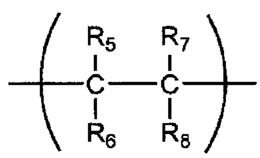

(II)

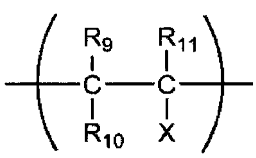

(III)

wherein

each occurrence of $R_5$, $R_6$, $R_7$, $R_8$, $R_9$, $R_{10}$, and $R_{11}$ is, independently, H, halogen, fluoroalkyl, or perfluoroalkyl; and
X is $-[OC(R_hR_i)-C(R_jR_k)]_q-O-[CR_lR_m]_z-SO_3H$,
wherein each occurrence of $R_h$, $R_i$, $R_j$, $R_k$, $R_l$ and $R_m$ is, independently, H, halogen, fluoroalkyl, or perfluoroalkyl;
q is 0 to 10; and
z is 1 to 5.

**26.** An ink composition comprising:

(a) a sulfonated conjugated polymer obtained by treating with a reducing agent a sulfonated conjugated polymer comprising a repeating unit having a quinoid structure;
(b) at least one amine compound;
(c) a liquid carrier comprising at least one organic solvent;
(d) one or more metal oxide nanoparticles; and
(e) optionally, a synthetic polymer comprising one or more acidic groups.

## INTERNATIONAL SEARCH REPORT

International application No. PCT/JP2018/001381

A. CLASSIFICATION OF SUBJECT MATTER
Int. Cl. H01L51/50(2006.01)i, C08G65/12(2006.01)i, C08K5/17(2006.01)i, C08L65/00(2006.01)i, C09D11/02(2014.01)i

According to International Patent Classification (IPC) or to both national classification and IPC

B. FIELDS SEARCHED

Minimum documentation searched (classification system followed by classification symbols)
Int. Cl. H01L51/50, C08G65/12, C08K5/17, C08L65/00, C09D11/02

Documentation searched other than minimum documentation to the extent that such documents are included in the fields searched

Published examined utility model applications of Japan 1922-1996
Published unexamined utility model applications of Japan 1971-2018
Registered utility model specifications of Japan 1996-2018
Published registered utility model applications of Japan 1994-2018

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2010-505005 A (PLEXTRONICS, INC.) 18 February 2010, claims, paragraphs [0195], [0259], [0271], & US 2008/0248313 A1, claims, paragraphs [0218], [0296], [0308] & WO 2008/073149 A2 & EP 2537874 A1 & KR 10-2009-0042800 A & CN 101563388 A | 1-26 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| | |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**

International application No.
PCT/JP2018/001381

C (Continuation). DOCUMENTS CONSIDERED TO BE RELEVANT

| Category* | Citation of document, with indication, where appropriate, of the relevant passages | Relevant to claim No. |
|---|---|---|
| A | JP 2012-528918 A (AIR PRODUCTS AND CHEMICALS, INC.) 15 November 2012, claims 1-2, 8-9 & US 2010/0308281 A1, claims 1, 2, 8, 9 & WO 2010/141129 A1 & KR 10-2013-0114559 A | 1-26 |
| A | JP 2011-510131 A (LEE, Sung-Joo) 31 March 2011, claims 1-4, paragraph [0096] & US 2011/0049432 A1, claims 1-4, paragraph [0097] & WO 2009/091184 A2 & EP 2239294 A2 & KR 10-2009-0079820 A & CN 101952349 A | 1-26 |
| A | JP 2012-172024 A (NAGASE CHEMTEX CORP.) 10 September 2012, claims 1-5 (Family: none) | 1-26 |
| A | WO 2016/100313 A1 (SOLVAY USA, INC.) 23 June 2016, claims, & KR 10-2017-0095318 A | 7-15 |
| P, A | JP 2017-88704 A (SHIN-ETSU POLYMER CO., LTD.) 25 May 2017, claims 1-5 (Family: none) | 1-26 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2017007065 A
- JP 2017126779 A
- WO 2016171935 A
- US 6602974 B, McCullough
- US 6166172 A, McCullough
- US 8017241 B
- WO 2008073149 A
- US 8865025 B
- US 20100292399 A
- US 2010010900 A
- US 20100108954 A
- US 7070867 B
- US 20050123793 A
- US 20040113127 A
- US 20060175582 A
- US 4356429 A
- US 4539507 A
- US 5247190 A
- US 5401827 A
- US 5047687 A
- US 5454880 A
- US 6812399 B
- US 6933436 B

### Non-patent literature cited in the description

- **LEBEDEV et al.** *Chem. Mater.,* 1998, vol. 10, 156-163
- **KRAFT et al.** Electroluminescent Conjugated Polymers-Seeing Polymers in a New Light. *Angew. Chem. Int. Ed.,* 1998, vol. 37, 402-428